# EUROPEAN PATENT SPECIFICATION

(11) **EP 1 737 114 B1**
(45) Date of publication and mention of the grant of the patent: **08.06.2011**
(21) Application number: 05720478.6
(22) Date of filing: 10.03.2005
(51) Int. Cl.: H01L 41/04, G04C 3/12

(54) **PIEZOELECTRIC ACTUATOR DRIVE DEVICE, ELECTRONIC DEVICE, AND DRIVE METHOD THEREOF**
PIEZOELEKTRISCHE STELLGLIED-ANSTEUEREINRICHTUNG, ELEKTRONISCHE EINRICHTUNG UND ANSTEUERVERFAHREN DAFÜR
DISPOSITIF D'ATTAQUE D'ACTIONNEUR PIEZOELECTRIQUE, DISPOSITIF ELECTRONIQUE ET SON PROCEDE D'ATTAQUE

(30) Priority: 10.03.2004 JP 2004067562
(43) Date of publication of application: 27.12.2006
(73) Proprietor: Seiko Epson Corporation, Tokyo 163-0811 (JP)
(72) Inventor: KAWAGUCHI, Takashi, Suwa-shi Nagano 3928502 (JP); SAWADA, Akihiro, Suwa-shi Nagano 3928502 (JP); YAMAZAKI, Yutaka, Suwa-shi Nagano 3928502 (JP); OKEYA, Makoto, Suwa-shi Nagano 3928502 (JP)
(74) Representative: Cloughley, Peter Andrew
(86) International application number: PCT/JP2005/004207
(87) International publication number: WO 2005/086337

(56) References cited:
- EP-A2- 0 562 817
- JP-A- 6 141 566
- JP-A- 6 141 566
- JP-A- 8 080 068
- JP-A- 8 080 068
- JP-A- 8 275 560
- JP-A- 8 275 560
- JP-A- 8 308 267
- JP-A- 8 308 267
- JP-A- 11 178 362
- JP-A- 11 178 362
- US-A- 4 973 876
- US-A- 5 061 882
- US-A- 5 130 619
- US-A- 5 612 598

## Description

### FIELD OF THE INVENTION

The present invention relates to an apparatus for driving a piezoelectric actuator and a drive method for α piezoelectric actuator.

### BACKGROUND ART

Piezoelectric elements have an excellent conversion ratio of electrical energy to mechanical energy, and excellent responsiveness. Various piezoelectric actuators that utilize the piezoelectric effects of piezoelectric elements have therefore been recently developed.

These piezoelectric actuators have as their primary constituent element a vibrator having a piezoelectric element, wherein the vibrator is composed, for example, of a plate-shaped reinforcing plate having a protrusion that contacts a driven body on one end thereof, piezoelectric elements affixed to both sides of the reinforcing plate, drive electrodes provided on the surfaces of these piezoelectric elements, and detection electrodes that are electrically insulated from the drive electrodes. An apparatus for driving a piezoelectric actuator is also known whereby a prescribed alternating-current is applied to the drive electrodes of the vibrator, the vibrator is excited by longitudinal vibrations that cause the vibrator to expand and contract in the longitudinal direction, and bending vibrations are induced whereby the vibrator oscillates in the direction orthogonal to the direction of the longitudinal vibrations (see Prior Art 1, for example).

With the drive control performed by this type of drive apparatus, a piezoelectric actuator rotates so that the protrusion of the vibrator traces an elliptical orbit, and the actuator drives the driven body that is in contact with the protrusion. An alternating-current voltage having the optimum vibration frequency for the selected design must be applied to the vibrator of the piezoelectric actuator, and the prescribed longitudinal vibration and bending vibration must be generated therein in order for the driven body to be driven at high efficiency. However, it is difficult to continually apply the optimum drive frequency for the selected design due to the effects of the circuit characteristics of the drive apparatus, the temperature, the drive torque, and the like. Feedback control is therefore implemented in this drive apparatus whereby a detection signal from detection electrodes provided to the piezoelectric elements is detected, and the drive frequency of the alternating-current voltage applied to the drive electrodes is adjusted based on the detection signal.
Specifically, it is known that the phase difference between the phase of the alternating-current voltage applied to the drive electrodes and the phase of the detection signal detected from the detection electrodes, or the phase difference among the detection signals detected from a plurality of detection electrodes, is dependent upon the drive frequency of the alternating-current voltage applied to the drive electrodes. In view of this, in this drive apparatus, the phase difference corresponding to the optimum drive frequency for the selected design of the piezoelectric actuator is set in advance as a reference phase difference, and the drive frequency of the alternating-current voltage applied to the drive electrodes is adjusted so that the detected phase difference is brought closer to the preset reference phase difference. Implementing such feedback control makes it possible to apply an alternating-current voltage with the optimum drive frequency for the vibrator of the piezoelectric actuator, and also makes it possible to excite the piezoelectric actuator with the prescribed longitudinal vibrations and bending vibrations and to drive the driven body with high efficiency.

### Prior Art 1: Japanese Patent Application Laid-Open No. 2002-291264

JP6-141566 discloses a control circuit which comprises a variable oscillator, an amplifier, a target r.p.m. setting section, and a phase difference control section. The phase difference control section determines a phase difference phi required for r.p.m. control based on output pulses from a speed detector for an ultrasonic motor and output pulses from the target r.p.m. setting section, receives output signals from a longitudinal oscillation sensor and a torsional oscillation sensor and controls the variable oscillator such that the outputs from the oscillation sensors have a phase difference identical to the phase difference phi determined based on the outputs from the target r.p.m. setting section and the speed detector. The oscillation output is then amplified through the amplifier and fed to the ultrasonic motor.

US5061882 discloses a vibration wave driven motor which comprises a comparator for comparing a resonance frequency of the motor with a power supply frequency and a frequency setter for setting the power supply frequency according to a predetermined algorithm in response to the output of the comparator. The frequency setter is provided with an algorithm which, if the power supply frequency is identified lower than the resonance frequency by the comparator, brings the power supply frequency toward an optimum frequency through a predetermined frequency higher than the resonance frequency.

US5130619 discloses a drive control apparatus for an ultrasonic motor having a vibrator with a piezoelectric element and an elastic element. The apparatus comprises a power source for supplying alternating power to the piezoelectric element, a voltage detecting device for detecting a voltage applied to the vibrator, a sensor for detecting a vibrator state signal dependent on vibrating velocity of the vibrator, and a control device for controlling the ultrasonic motor with reference to the vibrator state signal. For automatic resonant frequency tracking control, the control device controls oscillating frequency of the power source to maintain a phase difference between frequency of the vibrator obtained from the vibrator state signal and frequency of the voltage supplied to the vibrator at a predetermined value. For constant velocity amplitude control, the control device controls output voltage of the power source to maintain the vibrator state signal at a predetermined value.

### DISCLOSURE OF THE INVENTION

### PROBLEMS THE INVENTION IS INTENDED TO SOLVE

However, as a result of earnest research, the inventors have discovered that the frequency characteristics, which express the vibrating state of the vibrator detected from the detection electrode, depend on the drive voltage. Therefore, in Prior Art 1, there is a possibility that the optimum drive frequency cannot be applied to the vibrator of the piezoelectric actuator, even if the feedback of the drive frequency is controlled so that the phase difference between the phase of the drive voltage and the phase of the detection signal is brought closer to a preset target phase difference. Specifically, in conventional feedback control, in cases in which the drive voltage fluctuates, optimum control is not possible even if the drive frequency is adjusted based on the preset target phase difference, because the frequency characteristics of the vibrator also fluctuate according to the drive voltage. This leads to problems in that the range of applicable drive voltages is limited by the piezoelectric actuator, and the drive efficiency is severely reduced when a drive voltage outside of this specific voltage range is applied.

An object of the present invention is to provide an apparatus for driving a piezoelectric actuator wherein it is possible to use a wide range of drive voltages, and the piezoelectric actuator can be reliably driven with high efficiency, and also to provide an electronic device, a drive method thereof, a drive control program thereof, and a recording medium for recording this program.

### MEANS FOR SOLVING THESE PROBLEMS

The apparatus for driving a piezoelectric actuator according to the present invention is an apparatus for driving a piezoelectric actuator having a vibrator that vibrates due to the application of a drive signal having a prescribed drive frequency to a piezoelectric element; said apparatus for driving a piezoelectric actuator characterized by comprising:
drive means for supplying the drive signal to the piezoelectric element of the vibrator;
phase-shifting means for correcting a phase of a detection signal indicating the vibrating state of the vibrator based on the voltage of the detection signal;
phase difference detection means for detecting a phase difference between the drive signal and the detection signal whose phase has been corrected by the phase-shifting means;
comparison means for comparing the phase difference detected by the phase difference detection means and a target phase difference for optimizing the drive frequency of the vibrator ; and
control means for varying the drive frequency of the drive signal on the basis of the comparison results from the comparison means so that the phase difference detected by the phase difference detection means is brought closer to the target phase difference after said target phase difference and said phase difference detected by the phase difference detection means are compared by said comparison means.

The apparatus may further include target value setting means for setting a target value that will produce the desired vibrating state.

The phase shifting means corrects a phase of a detection signal that indicates the vibrating

Also, the phase shifting means makes corrections based on the voltage of the value that indicates the vibrating state. Therefore, the value that indicates the vibrating state can be immediately varied according to the fluctuation in drive voltage, allowing control to be rapidly and reliably implemented voltage of the value that indicates the vibrating state corresponds to the drive voltage, making it possible to similarly detect a fluctuation in drive voltage even when this voltage is detected.

In the apparatus for driving a piezoelectric actuator of the present invention, the vibrating state detection means is a phase difference detection means for detecting the phase difference between the drive signal and a detection signal indicating the vibrating state of the vibrator the correction means has voltage detection means for detecting the voltage of the detection signal, and also have phase difference variation means for varying the target phase difference on the basis of the voltages detected by the voltage detection means; and that the comparison means compare the phase difference and the changed target phase difference.

According to this configuration, the drive frequency can be varied rapidly because detection is performed to determine the phase difference between the drive signal and a detection signal indicating the vibrating state of the vibrator, the target phase difference that is the target value of this phase difference is corrected, and feedback control can be implemented based on the comparison between the phase difference and the corrected target phase difference. Specifically, as previously described, the dependence is known between the drive frequency of the drive voltage and the phase difference between the drive signal and the detection signal, and this dependence is such that the phase difference monotonically decreases with respect to the increase in drive frequency; i.e., the phase difference does not peak. Therefore, it is possible to immediately determine whether to increase or reduce the drive frequency on the basis of the relative size of the target phase difference and the phase difference detected by the phase difference detection means, and the speed of control can be increased. In this case, the value resulting from varying the target phase difference may be a discrete value set for each specific range of voltages, or a function value continuously set for each voltage.

In the apparatus for driving a piezoelectric actuator of the present invention, it is preferable that the phase shifting means be configured from a nonlinear element.

Also, the nonlinear element can be configured from a diode or a transistor in an off state.

Furthermore, in cases in which the nonlinear element is configured from a diode, the diode can be configured from the parasitic diode of an MOS transistor.

According to this configuration, constructing the phase shifting means from an ordinary diode, the parasitic diode of an MOS transistor, a transistor in an off state, or another such nonlinear element makes it possible for the phase of the detection signal to be shifted by a simple circuit configuration. Specifically, the phase of the detection signal is shifted as a result of the fact that the voltage value and the electric current value of the detection signal are made non-proportional by the nonlinear element. Also, the phase shifting means can be constructed inexpensively by using a diode, the parasitic diode of an MOS transistor, or a transistor in an off state.

The nonlinear element is not limited to the examples above, and can also be an element in which the size of the electric current varies in a nonlinear manner in relation to the size of the applied voltage, or a circuit including a combination of this type of element and a capacitor.

The electronic device of the present invention has any of the above-described apparatuses for driving a piezoelectric actuator, a piezoelectric actuator driven by this apparatus, and a power source.

According to the present invention, an electronic device can be provided in which, similar to the above-described apparatuses for driving a piezoelectric actuator, in cases in which the vibrating state of the vibrator deviates from the target value for a specific drive voltage, the relationship between the vibrating state and the target value can be properly modified, and the optimum drive frequency can be applied to achieve highly efficient driving.

Also, the method for driving an electronic device according to the present invention is a method for driving an electronic device comprising a piezoelectric actuator having a vibrator that vibrates due to the application of a drive signal having a prescribed drive frequency to a piezoelectric element, drive means for supplying the drive signal to the piezoelectric element of the vibrator, and a power source; said electronic device drive method characterized in comprising:
a phase-shifting step of correcting a phase of a detection signal indicating the vibrating state of the vibrator based on the voltage of the detection signal;
a phase difference detection step of detecting a phase difference between the drive signal and the detection signal whose phase has been corrected in the phase shifting step;
a comparison step of comparing the phase difference detected in the phase difference detection step and a target phase difference for optimizing the drive frequency of the vibrator after the phase of the detection signal has been corrected in the phase-shifting step; and
a control step of varying the drive frequency of the drive signal on the basis of the comparison results from the comparison step so that the phase difference detected in the phase difference detection step is brought closer to the target phase difference after said target phase difference and said phase difference detected in the phase difference detection step are compared in said comparison means.

According to the present invention, in cases in which the vibrating state of the vibrator deviates from the target value for a specific drive voltage, the relationship between the vibrating state and the target value can be properly modified, and the optimum drive frequency can be applied to achieve highly efficient driving in the same manner as in the above-described apparatus for driving a piezoelectric actuator or electronic device. Also, it is possible to use a wide range of drive voltages with a small variety of piezoelectric actuators, and the drive efficiency of the piezoelectric actuator can always be appropriately maintained, even in cases in which the power source voltage decreases or is non-uniform.

A computer can be made to function as some or all of the drive control means of the electronic device of the present invention whereby the optimum drive frequency can be applied to achieve highly efficient driving, and it is possible to use a wide range of drive voltages with one piezoelectric actuator in the same manner as in the above-described apparatus for driving a piezoelectric actuator or electronic device.

In a recording medium, it is preferable that a drive control program for an electronic device or the drive control program for a piezoelectric actuator be recorded in a manner that allows the program to be read by a computer as previously described.

According to this configuration, if the drive control program for the piezoelectric actuator or the electronic device is modified or improved, the program can be easily read by a computer and the program can be updated.

### EFFECTS OF THE INVENTION

According to the invention as described above, it is possible to provide an apparatus for driving a piezoelectric actuator wherein it is possible to use a wide range of drive voltages, and the piezoelectric actuator can be reliably driven with high efficiency, and also to provide an electronic device, a drive method thereof, a drive control program thereof, and a recording medium for recording this program.

### BRIEF DESCRIPTION OF THE DRAWINGS

FIG. 1 is a diagram showing the schematic configuration of an electronic device according to a first example;
FIG. 2 is a plan view showing the detailed configuration of a date display mechanism in the electronic device;
FIG. 3 is a diagram showing the vibrating state in the piezoelectric actuator;
FIG. 4 is a block diagram showing the drive control apparatus of the piezoelectric actuator;
FIG. 5 is a flowchart for describing the drive control method of the piezoelectric actuator;
FIG. 6 is a block diagram showing the drive control apparatus for a piezoelectric actuator according to a second example;
FIG. 7 is a block diagram showing the drive control apparatus for a piezoelectric actuator according to a first embodiment of the present invention;
FIG. 8 is a diagram showing an equivalent circuit of the phase-shifting means in the drive control apparatus;
FIG. 9 is a diagram showing the vibrating state in the piezoelectric actuator of the aforementioned examples and embodiment;
FIG. 10 is a diagram showing an equivalent circuit of the phase-shifting means in another configuration of the aforementioned embodiment;
FIG. 11 is a block diagram showing the drive control apparatus of a piezoelectric actuator according to a third example;
FIG. 12 is a block diagram showing a drive control apparatus in another configuration of the previous examples and embodiment;
FIG. 13 is a block diagram showing a drive control apparatus in another configuration of the previous examples and embodiment;
FIG. 14 is a block diagram showing the configuration of a power source and a drive control apparatus in an electronic device according to a second embodiment of the present invention;
FIG. 15 is a block diagram showing a drive unit, a power source, and a drive control apparatus in the electronic device;
FIG. 16 is a block diagram showing the configuration of a power source and a drive control apparatus in another configuration of the aforementioned examples and embodiments;
FIG. 17 is a block diagram showing a drive unit, a power source, and a drive control apparatus in another embodiment;
FIG. 18 is a perspective view showing the electronic device according to a fourth example and a third embodiment of the present invention; and
FIG. 19 is a detailed structural view showing the digit display unit in the electronic device.

### KEY

1: electronic timepiece (electronic device), 12: vibrator, 100, 200, 300, 400, 500, 600: drive control apparatus, 111, 211, 311, 411, 511, 611: drive circuit (drive means), 120, 220, 320: phase difference detection means (drive means), 121, 221, 321: waveform-shaping circuit, 122, 222, 322: phase difference/DC conversion circuit (phase difference/voltage conversion circuit), 130, 230, 430, 530, 630: correction means, 131, 231, 431, 531, 631: power-source voltage detecting circuit (voltage detection means), 133: comparison voltage setting means (phase difference variation means), 140, 240, 340, 440, 540, 640: drive frequency setting means (comparison means), 142, 242, 342, 442, 542, 642: integrating circuit (integrating means), 233: phase difference shifting circuit, 250, 350, 433, 533, 633: comparison voltage setting circuit (target value setting means), 330: phase-shifting means, 331, 332: diode, 333: capacitor, 334: MOS transistor, 334A: parasitic diode, 420: peak holding circuit (voltage detection means), 520, 620: electric current detection means, A: piezoelectric actuator, SD1: detection signal, SDR: drive signal

### BEST MODE FOR CARRYING OUT THE INVENTION

In the following, examples which do not form part of the invention and an embodiment of the invention are described.

### [1. First Example]

The first example will now be described with reference to the diagrams.

In the second and subsequent examples and embodiment hereinafter described, identical components and components having similar functions to those of the first example described below are denoted by the same symbols, and descriptions thereof are simplified or omitted.

### [1-1. Entire Configuration]

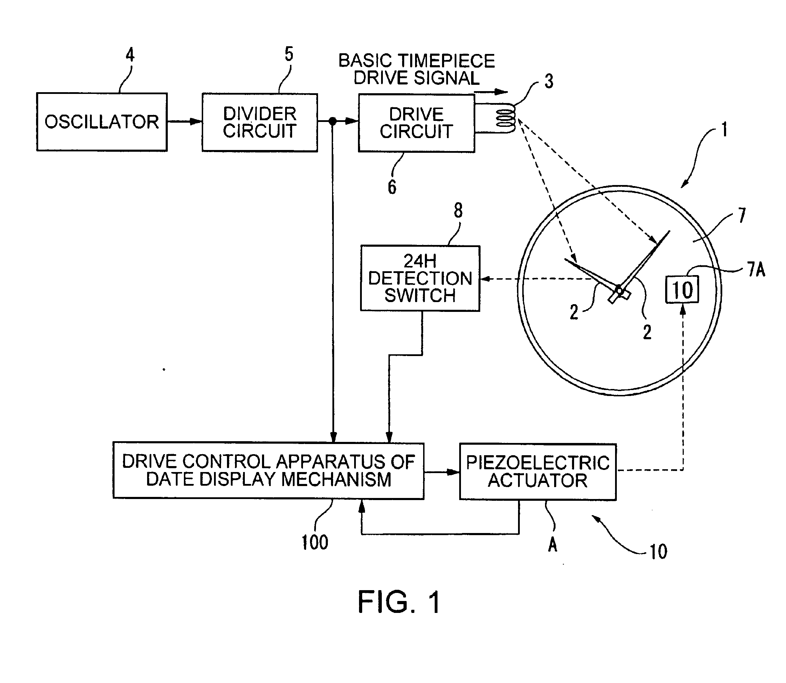

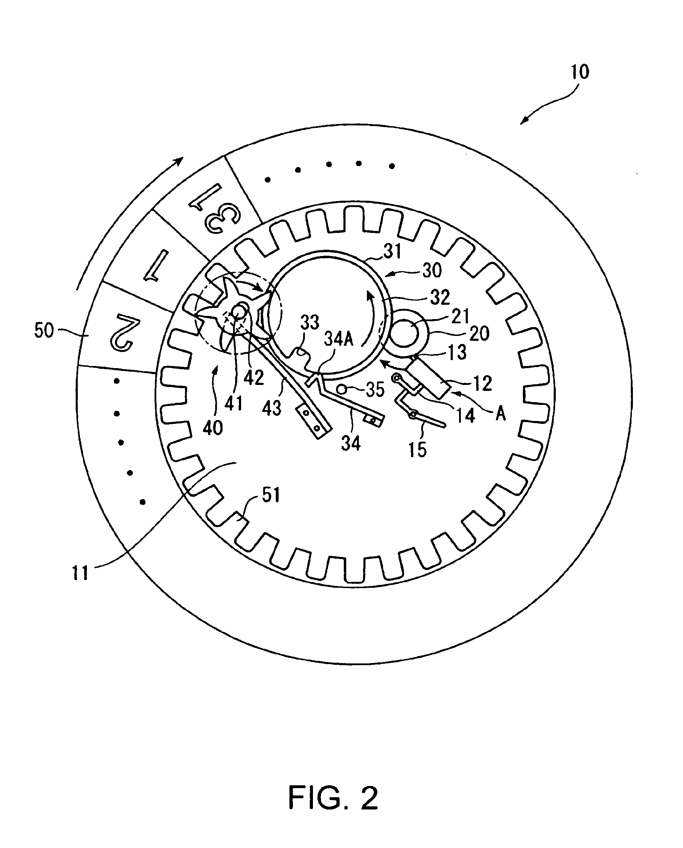

FIG. 1 is a diagram showing the schematic configuration of an electronic timepiece 1 as the electronic device in the present example. FIG. 2 is a plan view showing the detailed configuration of a date display mechanism 10 in the electronic timepiece 1.

As shown in FIG. 1, the electronic timepiece 1 is a wristwatch that has pointers 2 for displaying the time, and a stepping motor 3 for driving the pointers 2. The driving of the stepping motor 3 is controlled by an oscillator 4, a divider circuit 5, and a drive circuit 6. The oscillating circuit 4 has a reference oscillation source composed of a liquid crystal oscillator, and outputs a reference pulse. The divider circuit 5 inputs the reference pulse outputted from the oscillating circuit 4, and produces a standard signal (a signal of 1 Hz, for example) on the basis of the reference pulse. The drive circuit 6 generates a motor drive pulse for driving the stepping motor 3 on the basis of the reference signal outputted from the divider circuit 5.

The date display mechanism 10 of the electronic timepiece 1 has a piezoelectric actuator A and a drive control apparatus 100 for controlling the driving of the piezoelectric actuator A. A switch 8 that opens and closes by detecting the time (for example, 24 hours) of the electronic timepiece 1 acts as a trigger for the operation of the drive control apparatus 100, which drives the date display mechanism 10.

As shown in FIG. 2, the primary components of the date display mechanism 10 usually comprise a piezoelectric actuator A, a rotor 20 as the object to be rotatably driven by the piezoelectric actuator A, a deceleration gear train that decelerates and transmits the rotation of the rotor 20, and a date wheel 50 rotated by the drive force transmitted via the deceleration gear train. The deceleration gear train comprises a date turning intermediate wheel 30 and a date turning wheel 40. The piezoelectric actuator A, the rotor 20, the date turning intermediate wheel 30, and the date turning wheel 40 are supported on a bottom plate 11. The piezoelectric actuator A has a flat, thin rectangular vibrating body 12, and this vibrating body 12 is disposed so that the distal end thereof comes into contact with the outer peripheral surface of the rotor 20. A disc-shaped dial 7 is provided at the top of the date display mechanism 10, as shown in FIG. 1, and part of the outer peripheral surface of the dial 7 is provided with a window 7A for displaying the date, and is designed so that the date on the date wheel 50 is visible through the window 7A. Also, a movement or the like connected to the stepping motor 3 for driving the pointers 2 is provided at the bottom (rear side) of the bottom plate 11.

The date turning intermediate wheel 30 is configured from a large wheel 31 and a small wheel 32. The small wheel 32 has a cylindrical shape somewhat smaller than the large wheel 31, and a notch 33 with a substantial square shape is formed in the outer peripheral surface thereof. The small wheel 32 is fixed in place so as to have the same center as the large wheel 31. A gear 21 at the top of the rotor 20 meshes with the large wheel 31. Therefore, the date turning intermediate wheel 30 composed of the large wheel 31 and small wheel 32 rotates in conjunction with the rotation of the rotor 20.
A plate spring 34 is provided to the bottom plate 11 on the side of the date turning intermediate wheel 30, the proximal end of the plate spring 34 is fixed in place on the bottom plate 11, and the distal end 34A is bent into a rough V shape. The distal end 34A of the plate spring 34 is provided to be capable of going into and out of the notch 33 of the date turning intermediate wheel 30. A contact 35 is disposed at a position near the plate spring 34, and this contact 35 is designed to come into contact with the plate spring 34 when the date turning intermediate wheel 30 rotates and the distal end 34A of the plate spring 34 goes into the notch 33. A specific voltage is applied to the plate spring 34, and when the plate spring comes into contact with the contact 35, this voltage is applied to the contact 35 as well. Therefore, the turning state of the date wheel and the amount by which the date wheel 50 rotates in one day can be determined by determining the voltage of the contact 35.
The amount by which the date wheel 50 rotates is not limited to the use of the plate spring 34 or the contact 35, and another possibility is to utilize a component that determines the rotating state of the rotor 20 or the date turning intermediate wheel 30 and outputs specific pulse signals; i.e., a conventional photoreflector, a photointerrupter, an MR sensor, or other such various rotating encoders or the like.

The date wheel 50 has a ring shape, and an inner gear 51 is formed on the inner peripheral surface thereof. The date turning wheel 40 has a gear with five teeth, and meshes with the inner gear 51 of the date wheel 50. Also, a shaft 41 is provided in the center of the date turning wheel 40, and this shaft 41 is inserted into a through-hole 42 formed in the bottom plate 11. The through-hole 42 is formed extending along the peripheral direction of the date wheel 50. The date turning wheel 40 and the shaft 41 are urged upward and to the right in FIG. 2 by a plate spring 43 fixed on the bottom plate 11. The date wheel 50 is also prevented from oscillating by the urging action of the plate spring 43.

The vibrating body 12 of the piezoelectric actuator A is a rectangular plate having two long sides and two short sides. Also, the vibrating body 12 has a stacked structure in which a reinforcing plate made of stainless steel or the like is sandwiched between two rectangular plate-shaped piezoelectric elements. The plate has roughly the same shape as the piezoelectric elements, and is thinner than the piezoelectric elements. For the piezoelectric elements, lead zirconate titanate (PZT (trademark)), liquid crystal, lithium niobate, barium titanate, lead titanate, lead metaniobate, polyvinylidene fluoride, zinc lead niobate, scandium lead niobate, and the like can be used.
The vibrating body 12 has a contact unit 13 near the middle of one short side in the width direction. This contact unit 13 is obtained by cutting or otherwise shaping the reinforcing plate, and has a distal end with a gradually curving surface that protrudes from the piezoelectric elements. The vibrating body 12 maintains an orientation in which the distal end of the contact unit 13 is brought into contact with the outer peripheral surface of the rotor 20. A supporting member 14 and an urging member 15 are provided to the piezoelectric actuator A in order to keep the vibrating body 12 in such a position.

The supporting member 14 of the piezoelectric actuator A is formed integrally with the reinforcing plate by cutting or otherwise shaping the reinforcing plate. This supporting member 14 is an L-shaped member composed of a vertical part protruding vertically from the center of one long side of the vibrating body 12, and a horizontal part extending from the distal end of the vertical part towards the side of the rotor 20 parallel to the long sides. A pin protruding from the bottom plate 11 is inserted through the end of the horizontal part on the opposite side of the vertical part, and the supporting member 14 and the vibrating body 12 fixed thereon are capable of rotating around this pin as a rotational axis. One end of the urging member 15 is engaged near the center of the horizontal part of the supporting member 14. A pin protruding from the bottom plate 11 is inserted through the middle section of the urging member 15, which is capable of rotating around the pin as a rotational axis. Also, the end of the urging member 15 on the opposite side of the supporting member 14 engages with the bottom plate 11, and the pressure with which the contact unit 13 of the vibrating body 12 is pressed against the outer peripheral surface of the rotor 20 can be adjusted by varying the position of this end.

In the configuration described above, the vibrating body 12 of the piezoelectric actuator A produces longitudinal vibration, which is a first vibration mode, as well as bending vibration, which is a second vibration mode induced by the longitudinal vibration, as a result of a drive signal having a specific frequency being applied to the piezoelectric elements from the drive control apparatus 100, and the contact unit 13 moves while describing an elliptical arc within a plane containing the plate surface. The rotor 20 is struck on the outer peripheral surface by the contact unit 13 of the vibrating body 12, and is rotatably driven around the timepiece, as shown by the arrow in FIG. 2. The rotation of the rotor 20 is transmitted to the date turning wheel 40 via the date turning intermediate wheel 30, and the date turning wheel 40 causes the date wheel 50 to rotate around the timepiece. The transmissions of force from the vibrating body 12 to the rotor 20, from the rotor 20 to the deceleration gear train (the date turning intermediate wheel 30 and the date turning wheel 40), and from the deceleration gear train to the date wheel 50 all constitute a transmission of force in a direction parallel to the surface of the bottom plate 11 of the vibrating body 12. Therefore, coils or rotors are not stacked in the thickness direction as with a stepping motor, but the vibrating body 12 and the rotor 20 are disposed in the same plane, making it possible to reduce the thickness of the date display mechanism 10. Since the date display mechanism 10 can be made thinner, the entire electronic timepiece 1 can also be made thinner as well.

### [1-2. Configuration of the drive control apparatus of the piezoelectric actuator A]

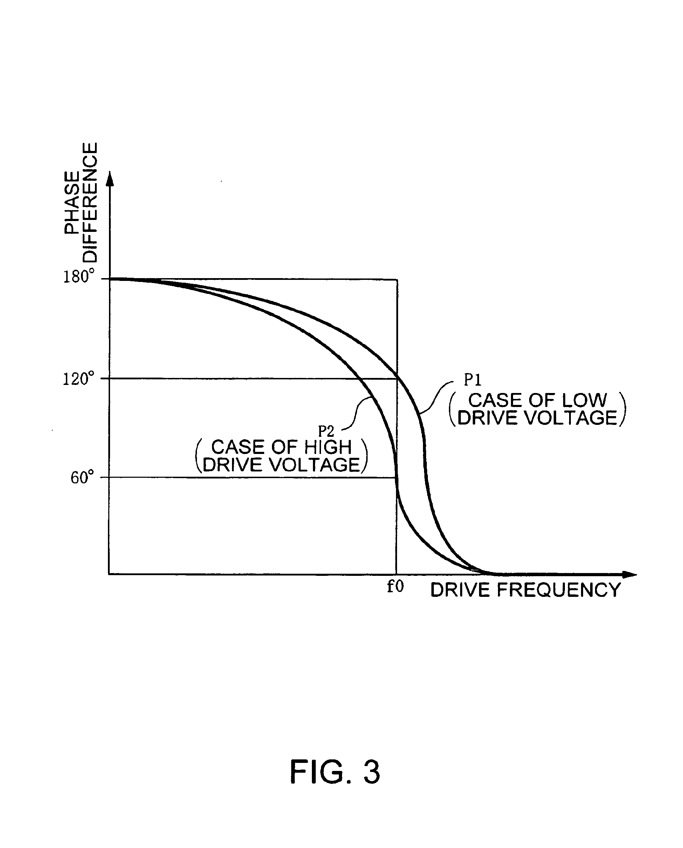

First, before the configuration of the drive control apparatus 100 is described, the relationship between the vibrating state of the vibrator 12 and the drive voltage of the applied drive voltage signal SDR will be described with reference to FIG. 3.

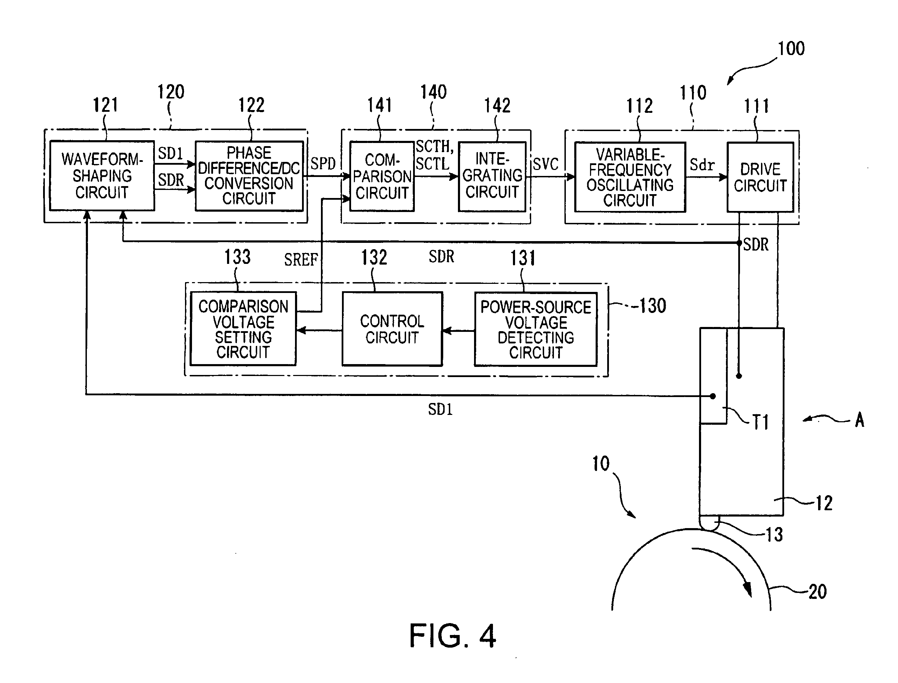

FIG. 3 is a diagram showing the manner in which the phase difference (value that indicates the vibrating state) between the detection signal SD1 and the drive voltage signal SDR from the vibrator 12 is related to the drive frequency of the drive voltage signal SDR. The detection signal SD1 is a signal obtained from a vibration detecting electrode T1 (FIG. 4) disposed on the piezoelectric element of the vibrator 12. This signal indicates that the vibrator 12 is vibrating. In this diagram, the upper curve P1 of the two curves shown depicts the relationship of the phase difference to the drive frequency when the drive voltage is relatively low (for example, 1 V), and the lower curve P2 depicts the relationship of the phase difference to the drive frequency when the drive voltage is relatively high (for example, 2V). Also, in this diagram, f0 indicates the optimum drive frequency of the piezoelectric actuator A. The phase difference at the optimum drive frequency f0 (300 kHz, for example) in the curve P1 is about 120°, while the phase difference at the optimum drive frequency f0 in the curve P2 is about 60°.

As described above, the phase difference between the detection signal SD1 and the drive voltage signal SDR, i.e., the vibrating state of the vibrator 12, depends on the size of the drive voltage, and the phase difference at the optimum drive frequency f0 fluctuates depending on the size of the drive voltage. Specifically, if the target phase difference at the optimum drive frequency f0 is set to 120° with the anticipation that the drive voltage will be relatively low (P1 in the diagram), but the drive voltage is instead high (P2 in the diagram), then the drive frequency at the target phase difference (120°) deviates towards frequencies lower than the optimum drive frequency f0. Therefore, it is clear from FIG. 3 that the optimum vibrating state for the vibrator 12 cannot be achieved even if the driving of the piezoelectric actuator A is controlled using the target phase difference as a reference.

Next, the drive control apparatus of the present example will be described with reference to FIG. 4.

FIG. 4 is a block diagram showing the drive control apparatus 100 of the present example.

In FIG. 4, the drive control apparatus 100 that controls the driving of the piezoelectric actuator A is designed in view of the dependence of the vibrating state of the vibrator 12 on the drive voltage. The apparatus is installed as a circuit on an IC chip. Specifically, in the drive control apparatus 100, the drive frequency is controlled according to the drive voltage of the drive voltage signal SDR after the target phase difference is corrected so that the relationship between the target phase difference and the phase difference between the detection signal SD1 and the drive voltage signal SDR produces the optimum drive frequency f0. The drive control apparatus 100 includes drive signal supply means 110, phase difference detection means 120, correction means 130 for correcting the target phase difference, and drive frequency setting means 140 as comparison means.

The drive signal supply means 110 applies a drive voltage signal SDR having a specified frequency to the drive electrode of the vibrator 12 on the basis of the comparison results of the drive frequency setting means 140. The drive signal supply means 110 includes a drive circuit 111 as drive means, and a variable-frequency oscillator 112.

The drive circuit 111 is a circuit that is electrically connected to the drive electrode of the vibrator 12, that amplifies an output signal Sdr outputted from the variable-frequency oscillator 112, and that sends a drive voltage signal SDR to the drive voltage of the vibrator 12.

The variable-frequency oscillator 112 is a circuit that oscillates at a frequency that corresponds to the frequency control voltage signal SVC outputted from the drive frequency setting means 140, and that outputs a signal Sdr to the drive circuit 111. In the present example, the oscillation frequency of the variable-frequency oscillator 112 has a specific fluctuation range that depends, for example, on temperature or the like.

The phase difference detection means 120 detects the drive voltage signal SDR outputted from the drive circuit 111 to the vibrator 12, and also detects the detection signal SD1 outputted from the detecting electrode T1 by the vibration of the vibrator 12 as a result of the fact that the drive voltage signal SDR is applied to the drive electrode of the vibrator 12. The phase difference detection means also detects the phase difference between the drive voltage signal SDR and the detection signal SD1. The phase difference detection means 120 includes a waveform-shaping circuit 121, and a phase difference/DC conversion circuit 122 as a phase difference/voltage conversion circuit.

The waveform-shaping circuit 121 is electrically connected to the drive circuit 11 and the detecting vibration electrode T1 of the vibrator 12. This circuit receives the drive voltage signal SDR outputted from the drive circuit 111 and the detection signal SD1 outputted from the detecting electrode T1, shapes the waveform of the drive voltage signal SDR and the detection signal SD1, and outputs the shaped drive voltage signal SDR and detection signal SD1 to the phase difference/DC conversion circuit 122.

In the present example, the phase difference between the detection signal SD1 and the drive voltage signal SDR is detected, another possibility is to provide a plurality of detection electrodes to the vibrator 12, and to detect the phase difference between a plurality of detection signals from this plurality of detection electrodes.

The phase difference/DC conversion circuit 122 is a circuit that outputs a signal that corresponds to the phase difference between the drive voltage signal SDR and the detection signal SD1 shaped by the waveform-shaping circuit 121. The phase difference/DC conversion circuit 122 includes a phase difference determination unit and a voltage-averaging unit (neither is shown). The phase difference determination unit generates phase difference signals whose pulse widths are equivalent to the phase difference of the drive voltage signal SDR and the detection signal SD1, and outputs these phase difference signals to the voltage-averaging unit. The voltage-averaging unit takes the average of the phase difference signals outputted from the phase difference determination unit, and outputs a phase difference signal SPD of a level proportionate to the phase difference of the drive voltage signal SDR and the detection signal SD1 to the drive frequency setting means 140.

The correction means 130 is a circuit that sets the target phase difference in accordance with the drive voltage and outputs a comparison voltage signal SREF equivalent to the target phase difference to the drive frequency setting means 140; i.e., the correction means varies the target phase difference according to the fluctuation in phase difference when the phase difference between the detection signal SD1 and the drive voltage signal SDR fluctuates according to the drive voltage. The correction means 130 includes a power-source voltage detecting circuit 131 as voltage detection means for detecting the power-source voltage (drive voltage), a control circuit 132 for varying the target phase difference according to the power-source voltage detected by the power-source voltage detecting circuit 131, and a comparison voltage setting circuit 133 as phase difference variation means (target value setting means) for varying the target phase difference as instructed by the control circuit 132 and presenting the drive frequency setting means 140 with a comparison voltage signal SREF equivalent to the varied target phase difference. The control circuit 132 presents the comparison voltage setting circuit 133 with a control signal corresponding to the power-source voltage detected by the power-source voltage detecting circuit 131.

The power-source voltage detecting circuit 131 is not limited to detecting the power-source voltage (drive voltage) and may also be configured so as to be connected to the vibration detecting electrode T1 of the vibrator 12 of the piezoelectric actuator A, and to detect the voltage value of the detection signal SD1 from the vibration detecting electrode T1.

The comparison voltage setting circuit 133 is a circuit that is controlled by the control circuit 132, and that presents the drive frequency setting means 140 with a comparison voltage signal SREF equivalent to a specified target phase difference. The comparison voltage setting circuit 133 includes an up/down counter and a D/A converter (neither is shown). The up/down counter is caused to perform up-counting input or down-counting input by a signal appropriately outputted from the control circuit 132, and is configured so as to raise or lower the counter value upon receiving these up and down-counting inputs. Also, the up/down counter is configured so as to set the counter value to a specified value; for example, the MAX counter value, by inputting the control signal outputted from the control circuit 132 when the piezoelectric actuator A begins to be driven. The up/down counter is configured, for example, from a 3 bit counter or the like, and the counter presents the D/A converter with a 3 bit counter value that depends on the up-counting input or down-counting input. A comparison voltage value that corresponds to the counter value of the up/down counter is set in the D/A converter. The D/A converter outputs presents the drive frequency setting means 140 with a comparison voltage signal SREF that is equivalent to the comparison voltage value correlated with the counter value upon input of the counter value outputted from the up/down counter.

The drive frequency setting means 140 performs drive control in which the drive frequency of the drive voltage signal SDR outputted from the drive signal supply means 110 is locked in the vicinity of the optimum drive frequency f0 for the selected design, so that the disparity between the phase difference detected by the phase difference detection means 120 and the target phase difference set by the correction means 130 is a value close to zero. The drive frequency setting means 140 includes a comparison circuit 141, an integrating circuit 142, and a drive control circuit (not shown) as control means.

The comparison circuit 141 compares the comparison voltage value of the comparison voltage signal SREF outputted from the comparison voltage setting circuit 133 and the voltage value of the phase difference signal SPD outputted from the phase difference detection means 120, and outputs this comparison information to the integrating circuit 142. The comparison circuit 141 is configured, for example, from a comparator or the like. The circuit outputs a high-level signal SCTH as comparison information to the integrating circuit 142 in cases in which the voltage value of the phase difference signal SPD is equal to or less than the comparison voltage value of the comparison voltage signal SREF. A low-level signal SCTL is outputted as comparison information to the integrating circuit 142 in cases in which the voltage value of the phase difference signal SPD is greater than the comparison voltage value of the comparison voltage signal SREF.

The integrating circuit 142 integrates the comparison information outputted from the comparison circuit 141, outputs the integrated information to the drive signal supply means 110, and varies the drive frequency of the drive voltage signal SDR outputted from the drive signal supply means 110. The integrating circuit 142 includes two AND gates, an up/down counter, and a D/A converter (none of which is shown). The AND gates receive the high-level signal SCTH and the low-level signal SCTL outputted from the comparison circuit 141, as well as a pulse signal outputted from the pulse generator of the drive control circuit (not shown), and output a signal to the up/down counter in accordance with the input timing of the pulse signal. Specifically, upon inputting a high-level signal SCTH outputted from the comparison circuit 141, the AND gates output a signal to the up/down counter according to the input timing of the pulse signal to enact up-counting input. Also, upon input of a low-level signal SCTH outputted from the comparison circuit 141, the AND gates output a signal to the up/down counter in accordance with the input timing of the pulse signal to enact down-counting input. The up-down counter integrates the comparison information inputted via the AND gates. The up-down counter is configured, for example, from a 12-bit counter or the like. The counter raises or lowers the counter value according to the signal from the AND gates. Also, the up-down counter is configured so as to set the counter value to 0 as a result of the fact that a signal from the drive control circuit is inputted to a RESET input terminal. The up-down counter then raises or lowers the counter value in accordance with the signal from the AND gates, and outputs a 12-bit counter value to the D/A converter. A frequency control voltage value is set according to the counter value of the up-down counter in the D/A converter. When the D/A converter inputs the counter value outputted from the up-down counter, a frequency control voltage signal SVC equivalent to the frequency control voltage value that corresponds to the counter value is outputted to the variable-frequency oscillator 112 of the drive signal supply means 110.

In the time between the starting and stopping of the driving of the piezoelectric actuator A, the drive control circuit of the drive frequency setting means 140 appropriately outputs control instruction signals to the correction means 130 and the integrating circuit 142 to control these two circuits 130 and 142. This drive control circuit includes a pulse generator, a differentiating circuit, and a timer circuit (none of which is shown). The pulse generator is, for example, a circuit for outputting a pulse signal that has a specified frequency and is based on the reference oscillation signal of a liquid crystal oscillator, a ceramic oscillator, or the like. For example, this pulse generator outputs a pulse signal to the two AND gates of the integrating circuit 142 and to the timer circuit. The differentiating circuit is a circuit in which, upon input from the switch 8 of a start signal that indicates 12:00 am and instructs the piezoelectric actuator A to begin driving, i.e., a start signal that instructs the date wheel 50 (FIG. 2) to begin rotating, a pulse signal is outputted in accordance with the input timing of the start signal. The differentiating circuit outputs a pulse signal to the up-down counter of the comparison voltage setting circuit 133, to the up-down counter of the integrating circuit 142, and to the timer circuit.

### [1-3. Drive control method for the piezoelectric actuator A]

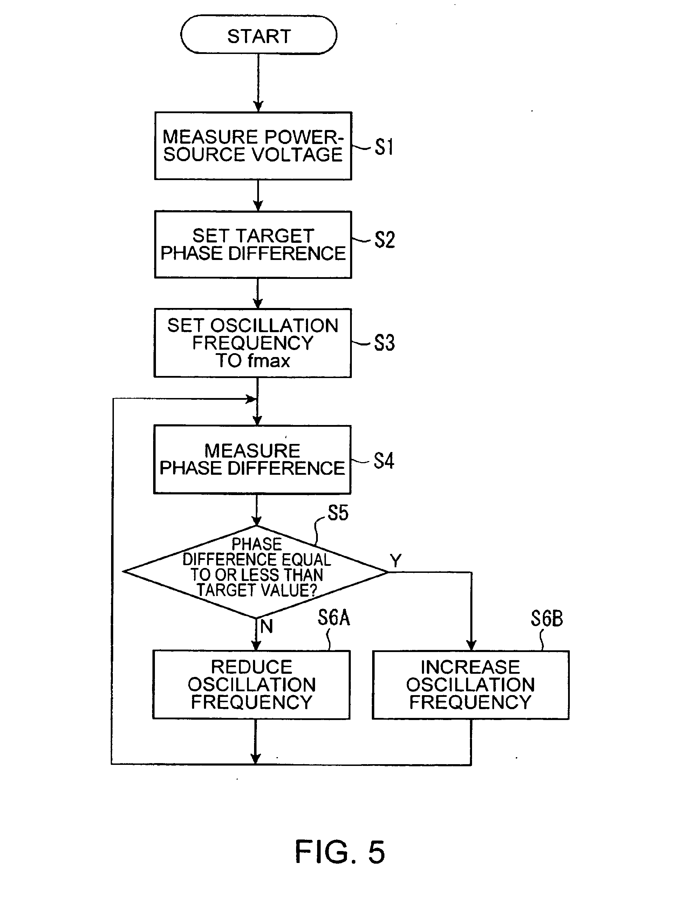

FIG. 5 is a flow chart for describing the drive control method for the piezoelectric actuator A.

Upon input of the start signal from the switch 8, the control circuit of the drive frequency setting means 140 outputs a control signal to the power-source voltage detecting circuit 131 of the correction means 130, and causes the power-source voltage detecting circuit 131 to detect the power-source voltage (drive voltage) (step S1).

The control circuit 132 of the correction means 130 outputs a control signal based on the detected power-source voltage to the comparison voltage setting circuit 133, and causes the comparison voltage setting circuit 133 to set a target phase difference corresponding to the power-source voltage (step S2, correction step, target value setting step). The comparison voltage setting circuit 133 then presents the drive frequency setting means 140 with a comparison voltage signal SREF equivalent to the set target phase difference. For example, the target phase difference outputted as the comparison voltage signal SREF is set to 120° when the power-source voltage is low (as in P1 in FIG. 3), i.e., when the power-source voltage 1V; and is set to 60° when the power-source voltage is high (as in P2 in FIG. 3), i.e., when the power-source voltage is 2V.

As step S 1 is being performed, the drive control circuit of the drive frequency setting means 140 causes a frequency control voltage signal SVC equivalent to a preset maximum frequency fmax to be outputted from the integrating circuit 142 to the variable-frequency oscillator 112 of the drive signal supply means 110 (step S3).

When step S3 is complete, a drive voltage signal SDR having a specified drive frequency (the minimum drive frequency fmax) is applied from the drive signal supply means 110 to the vibrator 12 of the piezoelectric actuator A, causing the vibrator 12 to vibrate. The drive voltage signal SDR is also outputted to the phase difference detection means 120.

A detection signal SD1 is outputted from the vibration detecting electrode T1 as a result of the vibration of the vibrator 12. The phase difference detection means 120 then detects the phase difference between the detection signal SD1 and the drive voltage signal SDR (step S4, vibrating state detection step), and outputs a phase difference signal SPD to the comparison circuit 141 of the drive frequency setting means 140.

The comparison circuit 141 of the drive frequency setting means 140 then compares the comparison voltage value of the comparison voltage signal SREF outputted from the comparison voltage setting circuit 133 and the voltage value of the phase difference signal SPD outputted from the phase difference detection means 120 (step S5, comparison step). Specifically, the comparison circuit 141 determines whether the phase difference detected by the phase difference detection means 120 is equal to or less than the target phase difference (120° or 60°).

In step S5, a signal SCTL is outputted to the integrating circuit 142 if the comparison circuit 141 has determined that the voltage value of the phase difference signal SPD is greater than the comparison voltage value of the comparison voltage signal SREF ("No"). When the integrating circuit 142 inputs the signal SCTL, the up-down counter performs a countdown and lowers the counter value by 1. The frequency control voltage value outputted from the integrating circuit 142 is thereby reduced, and the drive frequency of the drive voltage signal SDR outputted from the drive signal supply means 110 is reduced (step S6A, control step).

Repeating steps S5 and S6A and reducing the drive frequency of the drive voltage signal SDR cause the drive frequency of the drive voltage signal SDR to fall below the optimum drive frequency f0 for the selected design. At this time, in step S5, the comparison circuit 141 of the drive frequency setting means 140 determines that the voltage value of the phase difference signal SPD is less than the comparison voltage value of the comparison voltage signal SREF, and outputs a signal SCTH to the integrating circuit 142.

When the integrating circuit 142 inputs the signal SCTH, the up-down counter performs a count-up and raises the counter value by 1. The frequency control voltage value outputted from the integrating circuit 142 is thereby increased by a specified value, and the drive frequency of the drive voltage signal SDR outputted from the drive signal supply means 110 increases by a specified value (step S6B, control step).

As described above, the drive voltage signal SDR reaches a drive frequency in the vicinity of the optimum drive frequency f0, and feedback control is performed whereby the vibrating state of the vibrator 12 is optimally controlled. The piezoelectric actuator A continues to be driven until it is stopped at the point where the amount of rotation of the date wheel 50 reaches a specified amount, as detected by the contact 35 of the date turning intermediate wheel 30 in the date display mechanism 10.

Steps S1, S2, and S5 may be repeated after steps S6A and S6B are complete. This allows the power-source voltage to be detected as needed with each repetition by the power-source voltage detecting circuit 131 of the correction means 130, and the target phase difference to be reset by the comparison voltage setting circuit 133 on the basis of the power-source voltage. It is therefore possible to correct any deviation of the phase difference from the target phase difference due to fluctuations in the power-source voltage.

### [1-4. Effects of the first example]

The first example described above has the following effects.
(1) Specifically, the drive of the piezoelectric actuator A is controlled by means of feedback control, wherein the target phase difference is corrected by the comparison voltage setting circuit 133 of the correction means 130 on the basis of the power-source voltage detected by the power-source voltage detecting circuit 131, a comparison is made between the corrected target phase difference and the phase difference between the detection signal SD1 and the drive voltage signal SDR, and the drive frequency of the drive voltage signal SDR is varied based on the comparison result. In cases in which the vibrating state of the vibrator 12 deviates from the target value at a certain power-source voltage, the relationship between the vibrating state and the target value can thereby be properly corrected, and the optimum drive frequency can be applied to achieve highly efficient driving.

(2) Also, there is no need to prepare multiple piezoelectric actuators A in accordance with the power-source voltages in the electronic timepiece 1, and it is possible to use a small variety of piezoelectric actuators A in electronic timepieces having a wide range of power-source voltages.

(3) Furthermore, in cases in which the power-source voltage decreases or becomes nonuniform because of the specific service conditions, service period, or other parameters of the electronic timepiece 1, detecting the power-source voltage during the drive start or feedback control of the piezoelectric actuator A and resetting the target phase difference on the basis of this voltage will make it possible to implement drive control in which the effects of voltage fluctuation are avoided and the drive efficiency of the piezoelectric actuator A can always be appropriately maintained.

(4) Also, feedback control is performed based on the comparison of phase differences that decreases monotonically with an increase in drive frequency. Therefore, the comparison circuit 141 can immediately determine whether to increase or reduce the drive frequency on the basis of the relationship between the target phase difference and the phase difference between the detection signal SD1 and the drive voltage signal SDR as detected by the phase difference detection means 120, and drive control can be rapidly achieved.

(5) Also, the comparison information outputted from the comparison circuit 141 is integrated by the integrating circuit 142 of the drive frequency setting means 140, and the integrated information is outputted to the drive signal supply means 110, whereby the effect of nonuniformities in the detection signal SD1, the drive voltage, or the like is made less pronounced by control based on the integrated results of at least two comparisons, rather than control performed using the result of a single comparison, and the precision and efficiency of feedback control can be improved.

(6) The phase difference detection means 120 includes a waveform-shaping circuit 121 and a phase difference/DC conversion circuit 122, and the phase difference of the drive voltage signal SDR and the detection signal SD1 is outputted as a voltage value from the phase difference/DC conversion circuit 122. Therefore, the comparison circuit 141 for comparing the voltage value of this phase difference and the voltage value of the target phase difference can be configured from a comparator or another such simple and inexpensive device, and the structure of the drive control apparatus 100 can be simplified.

(7) Also, if the date display mechanism 10 is driven by the piezoelectric actuator A, highly efficient driving can be achieved with a small and thin configuration, and the electronic timepiece 1 can be further reduced in size.

### [2. Second example]

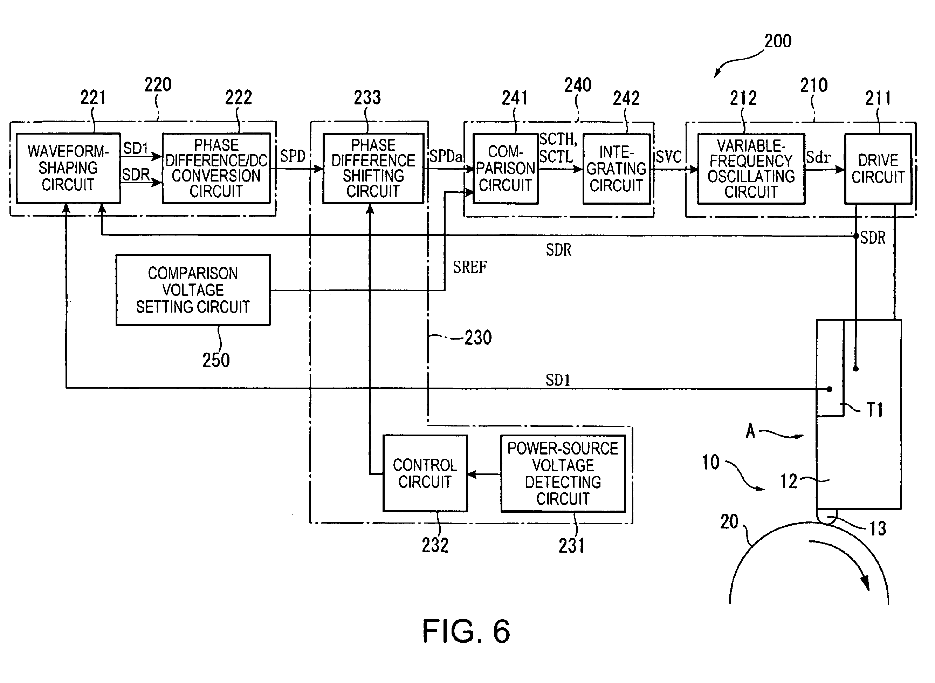

Next, the second example will be described with reference to FIG. 6.

FIG. 6 is a block diagram showing the drive control apparatus 200 of the present example.

The second example relates to an electronic timepiece 1 having the same configuration as in the above-described first example. The timepiece differs in terms the drive control apparatus 200 of the piezoelectric actuator A for driving the date display mechanism 10.

Specifically, in the first example, feedback control was implemented in which the target phase difference, which was the target value of the vibrating state of the piezoelectric actuator A, was corrected by the correction means; a comparison was made between the corrected target phase difference and the phase difference between the detection signal SD1 and the drive voltage signal SDR; and the drive frequency of the drive voltage signal SDR was varied based on the comparison result.

The second example differs from the first in that the phase difference between the detection signal SD1 and the drive voltage signal SDR, which expresses the vibrating state of the piezoelectric actuator A, is corrected; a comparison is made between the corrected phase difference and a preset target phase difference; and feedback control is performed based on the comparison result. The differences are described in detail hereinbelow.

### [2-1. Configuration of drive control apparatus of piezoelectric actuator A]

The drive control apparatus 200 includes drive signal supply means 210, phase difference detection means 220, correction means 230 for correcting the detected phase difference, drive frequency setting means 240 as comparison means, and a comparison voltage setting circuit 250 for setting the target phase difference.

The drive signal supply means 210, the phase difference detection means 220, and the drive frequency setting means 240 herein have the same configuration as the drive signal supply means 110, the phase difference detection means 120, and the drive frequency setting means 140 of the first example, respectively. The drive signal supply means 210 includes a drive circuit 211 and a variable-frequency oscillating circuit 212; the phase difference detection means 220 includes a waveform-shaping circuit 221 and a phase difference/DC conversion circuit 222 as a phase difference/voltage conversion circuit; and the drive frequency setting means 240 includes a comparison circuit 241, an integrating circuit 242, and a drive control circuit as control means (not shown). The comparison voltage setting circuit 250 is a circuit that presents the drive frequency setting means 240 with a comparison voltage signal SREF equivalent to a preset target phase difference.

The correction means 230 is a circuit that shifts (phase difference shifting means) the phase difference detected by the phase difference detection means 220 in accordance with the drive voltage, and outputs the shifted phase difference to the drive frequency setting means 240. Specifically, when the phase difference between the detection signal SD1 and the drive voltage signal SDR has fluctuated in accordance with its dependence on the drive voltage, the correction means shifts and corrects the phase difference by the amount of fluctuation. The correction means 230 includes a power-source voltage detecting circuit 231 as voltage detection means for detecting the power-source voltage (drive voltage); a control circuit 232 for issuing a command that indicates the amount of the phase difference shift in accordance with the power-source voltage detected by the power-source voltage detecting circuit 231 ; and a phase difference shifting circuit 233 that varies the voltage value of a phase difference signal SPD corresponding to the phase difference upon receiving the instruction from the control circuit 232, and outputs a changed phase difference signal SPDa to the drive frequency setting means 240.

The power-source voltage detecting circuit 231 is not limited to detecting the power-source voltage (drive voltage), and may be connected to the vibration detecting electrode T1 of the vibrator 12 of the piezoelectric actuator A and configured so as to detect the voltage value of the detection signal SD1 from the vibration detecting electrode T1.

The drive frequency setting means 240 performs drive control in which the drive frequency of the drive voltage signal SDR outputted from the drive signal supply means 210 is locked in the vicinity of the optimum drive frequency f0 for the selected design so that the disparity between the phase difference shifted by the phase difference shifting circuit 233 of the correction means 230 and the target phase difference set by the comparison voltage setting circuit 250 is a value close to zero. Specifically, the drive frequency setting means 240 outputs a high-level signal SCTH as comparison information to the integrating circuit 242 when the voltage value of the shifted phase difference signal SPDa is equal to or less than the comparison voltage of the comparison voltage signal SREF. Also, a low-level signal SCTL is outputted as comparison information to the integrating circuit 242 when the voltage value of the phase difference signal SPDa is greater than the comparison voltage value of the comparison voltage signal SREF.

### [2-2. Drive control method of piezoelectric actuator A]

The drive control method for the piezoelectric actuator A in which the drive control apparatus 200 of the present example is used is substantially similar to the drive control method of the above-described first example, and differs in that the phase difference is shifted in step S2 in FIG. 5, and in that steps S1, S2, and S5 are repeated after steps S6A and S6B. Specifically, after driving is initiated and the signal generating frequency is set to a preset maximum frequency fmax (step S3), the power-source voltage (drive voltage) is detected by the power-source voltage detecting circuit 231 (step S1), the phase difference is shifted by the phase difference shifting circuit 233 on the basis of the detected power-source voltage (step S2), the shifted phase difference is compared with the target phase difference (step S5), and the signal generating frequency is either reduced or increased on the basis of these comparison results (steps S6A, S6B). Sequentially repeating these steps S1, S2, S5, S6A, and S6B implements feedback control, whereby the drive voltage signal SDR reaches a drive frequency in the vicinity of the optimum drive frequency f0, and the vibrating state of the vibrator 12 is controlled in an optimal manner.

### [2-3. Effects of second example]

In the second example described above, the following effects are obtained in addition to the effects described above in (2) and (4) through (7).
(8) Specifically, feedback control is performed in which the phase difference between the detection signal SD1 and the drive voltage signal SDR is shifted by the phase difference shifting circuit 233 of the control means 130 on the basis of the power-source voltage detected by the power-source voltage detecting circuit 231, a comparison is made between the shifted phase difference and a target phase difference, and the drive frequency of the drive voltage signal SDR is varied on the basis of this comparison result. As a result of such feedback control, drive control for the piezoelectric actuator A is performed in which the relationship between the vibrating state and the target value thereof can be properly revised and the optimum drive frequency can be applied to achieve highly efficient driving even in cases in which the vibrating state of the vibrator 12 deviates from the target value in accordance with its dependence on the power-source voltage.

(9) Furthermore, in cases in which the power-source voltage decreases or becomes nonuniform because of the specific service conditions, service period, or other parameters of the electronic timepiece 1, detecting the power-source voltage during the drive start and the feedback control of the piezoelectric actuator A, and shifting the phase difference on the basis of this voltage will make it possible to implement drive control in which the effects of voltage fluctuation are avoided and the drive efficiency of the piezoelectric actuator A can always be appropriately maintained.

### [3. Embodiment of the present invention]

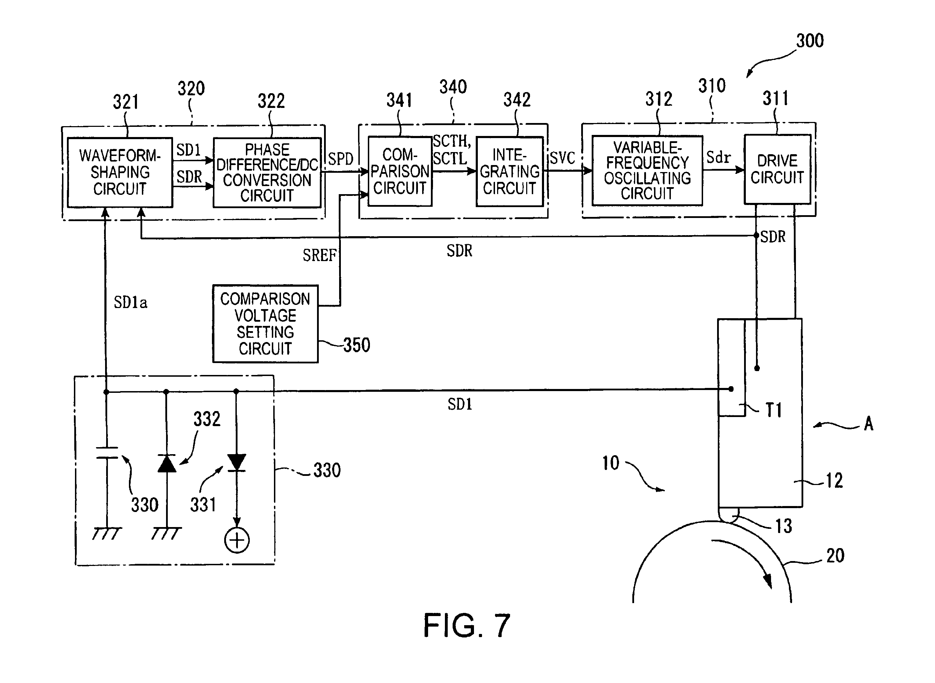

Next, an embodiment of the present invention will be described with reference to FIGS. 7 through 9.

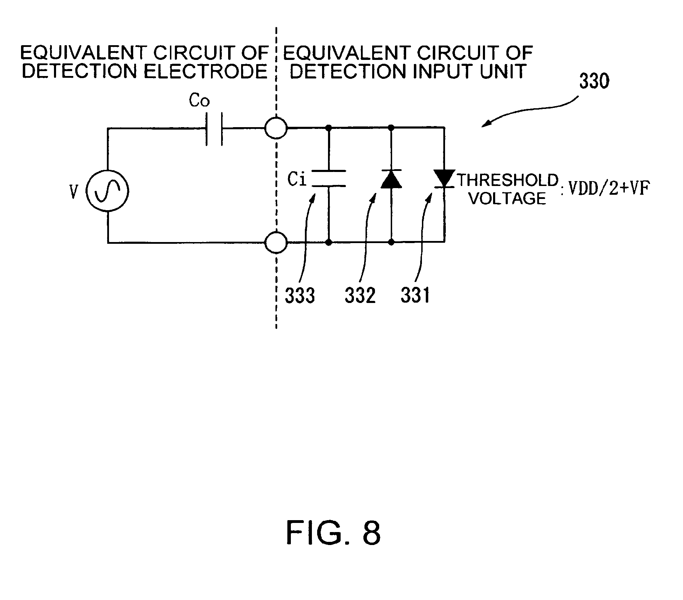

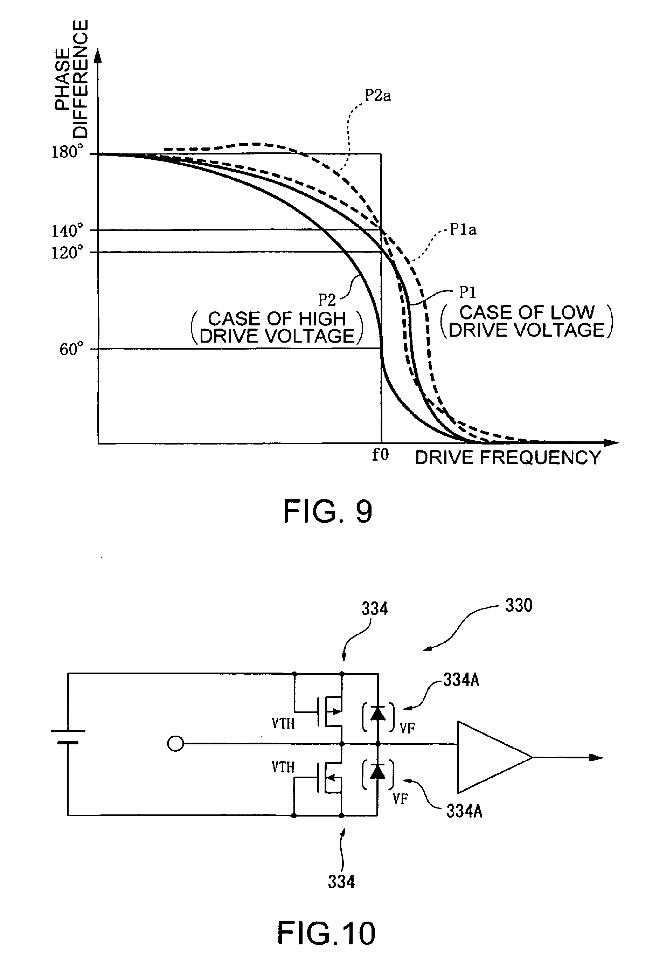

FIG. 7 is a block diagram showing the drive control apparatus 300 of the present embodiment. FIG. 8 is a diagram showing the equivalent circuit of the phase-shifting means 330 in the drive control apparatus 300. FIG. 9 is a diagram showing the relationship between the drive frequency of the drive voltage signal SDR, and the phase difference (value expressing the vibrating state) between the detection signal SD1 and the drive voltage signal SDR from the vibrator 12.

The embodiment relates to an electronic timepiece 1 having the same configuration as in the above-described first and second examples. The timepiece differs in terms of the drive control apparatus 300 of the piezoelectric actuator A for driving the date display mechanism 10.

Specifically, in the first example, feedback control was implemented in which the target phase difference, which was the target value of the vibrating state of the piezoelectric actuator A, was corrected by the correction means; a comparison was made between the corrected target phase difference and the phase difference between the detection signal SD1 and the drive voltage signal SDR; and the drive frequency of the drive voltage signal SDR was varied based on the comparison result. Also, in the second example, feedback control was implemented in which the phase difference between the detection signal SD 1 and the drive voltage signal SDR, which expresses the vibrating state of the piezoelectric actuator A, was shifted; a comparison was made between this shifted phase difference and a preset target phase difference; and the drive frequency of the drive voltage signal SDR was varied based on the comparison result.

The embodiment differs in that the phase of the detection signal SD1 that expresses the vibrating state of the piezoelectric actuator A is corrected, the phase difference between the detection signal SD 1a whose phase has been corrected and the drive voltage signal SDR is detected, a comparison is made between the detected phase difference and a preset target phase difference, and feedback control is performed based on the comparison result. The differences are described in detail hereinbelow.

### [3-1. Configuration of drive control apparatus of piezoelectric actuator A]

The drive control apparatus 300 includes drive signal supply means 310, phase difference detection means 320, phase-shifting means 330 as correction means for correcting the phase of the detection signal SD1, drive frequency setting means 340 as comparison means, and a comparison voltage setting circuit 350 for setting the target phase difference.

The drive signal supply means 310, the phase difference detection means 320, the drive frequency setting means 340, and the comparison voltage setting circuit 350 have substantially the same configurations as the drive signal supply means 110 and 210, the phase difference detection means 120 and 220, and the drive frequency setting means 140 and 240 of the first and second examples, and the comparison voltage setting circuit 250 of the second example. The drive signal supply means 310 includes a drive circuit 311 and a variable-frequency oscillating circuit 312; the phase difference detection means 320 includes a waveform-shaping circuit 321 and a phase difference/DC conversion circuit 322 as a phase difference/voltage conversion circuit; and the drive frequency setting means 340 includes a comparison circuit 341, an integrating circuit 342, and a drive control circuit as control means (not shown). The phase difference detection means 320 detects the phase difference between the drive voltage signal SDR and the detection signal SD1a whose phase has been shifted by the phase-shifting means 330, and outputs a phase difference signal SPD corresponding to the detected phase difference to the drive frequency setting means 340.

The phase-shifting means 330 is a circuit that shifts the phase of the detection signal SD1 in accordance with the drive voltage, and outputs the detection signal SD1a whose phase has been shifted to the phase difference detection means 320. Specifically, when the voltage value of the detection signal SD1 has fluctuated in accordance with its dependence on the drive voltage, the phase-shifting means corrects the phase of the detection signal SD1 by shifting it according to the fluctuation. The phase-shifting means 330 includes two diodes 331 and 332 and a capacitor 333 that are connected between the vibration detecting electrode T1 of the vibrator 12 and the phase difference detection means 320. One diode 331 from among the two diodes 331 and 332 is connected to the positive electrode side, and the other diode 332 and the capacitor 333 are connected to the ground side.

The parasitic capacitance of the diodes 331 and 332 can be used instead of the capacitor 333, and the capacitor 333 can be omitted by optimizing the size of the diodes 331 and 332.

The equivalent circuit of the phase-shifting means 330 is shown in FIG. 8, and the phase of the detection signal SD1 can be shifted using the equivalent circuit in accordance with the following operation.

Specifically, in the equivalent circuit in FIG. 8, an electric current does not flow to the diodes 331 and 332 in cases in which the voltage value V of the detection signal SD1 is equal to or less than the threshold voltage of the diodes 331 and 332. Therefore, the voltage value V of the detection signal SD1 is divided by the output capacitance of the detection electrode and the input capacitance of the capacitor 333, and the phase of the detection signal SD1 is not shifted.

In cases in which the voltage value V of the detection signal SD1 exceeds the threshold voltage of the diodes 331 and 332, an electric current flows to the diodes 331 and 332. This produces a circuit configuration that is equivalent to a circuit in which resistance is connected in parallel with the input capacitance of the capacitor 333. Therefore, the phase of the voltage generated in the input terminal is shifted in relation to the detection signal SD 1.

The shifted amount θ of the phase of the detection signal SD1 is shown in the following formulas (1) through (4), wherein VDD is the power-source voltage (drive voltage), VF is the threshold voltage of the diodes 331 and 332, Ci is the input capacitance of the capacitor 333, and C0 is the output capacitance of the detection electrode. Specifically, when the voltage value V is equal to or less than the threshold voltage as shown in formula (1), the shifted amount 0 is zero as shown in formula (2), and when the voltage value V exceeds the threshold voltage as shown in formula (3), the shifted amount θ is as shown in formula (4).

$\begin{matrix}\left[Eq. 1\right] \\ V \leq \left(\frac{Ci + C ⁢ 0}{C ⁢ 0}\right) \cdot \left(\frac{1}{2}⁢VDD+VF\right)\end{matrix}$

$\begin{matrix}\left[Eq. 2\right] \\ θ = 0\end{matrix}$

$\begin{matrix}\left[Eq. 3\right] \\ V \geq \left(\frac{Ci + C ⁢ 0}{C ⁢ 0}\right) \cdot \left(\frac{1}{2}⁢VDD+VF\right)\end{matrix}$

$\begin{matrix}\left[Eq. 4\right] \\ θ = {tan}^{- 1} ⁢ \left(\sqrt{\frac{{\left(\frac{V - \left(\frac{1}{2}⁢VDD+VF\right)}{V}\right)}^{2} - {\left(\frac{Ci}{Ci + C ⁢ 0}\right)}^{2}}{1 - {\left(\frac{V - \left(\frac{1}{2}⁢VDD+VF\right)}{V}\right)}^{2}}}\right)\end{matrix}$

As described above, it is clear from FIG. 9 that the phase difference between the detection signal SD 1 a and the drive voltage signal SDR is shifted in a higher direction (upward in the diagram) than the phase difference between the original (unshifted) detection signal SD1 and the drive voltage signal SDR. In this diagram, the two curves P1 and P2 shown by the solid lines indicate the phase difference between the unshifted detection signal SD1 and the drive voltage signal SDR. The curves depict the relationship of the phase difference to the drive frequency in cases in which the drive voltage is relatively low (1V, for example) and in cases in which the drive voltage is relatively high (2V, for example), as previously described in relation to the first example. The two curves P1a and P2a shown by the dashed lines indicate the phase difference between the shifted detection signal SD1a and the drive voltage signal SDR when the drive voltage is both relatively low and relatively high. In this diagram, the phase differences of the curves P1a and P2a at the optimum drive frequency f0 are both about 140°. It is clear from the formulas that the shifted amount when the drive voltage is relatively high is greater than the shifted amount when the drive voltage is relatively low because the voltage value of the detection signal SD1 increases together with the drive voltage.

Regardless of whether the drive voltage is low or high, the phase difference between the shifted detection signal SD1a and the drive voltage signal SDR is substantially the same at the optimum drive frequency f0. In other words, the threshold voltage of the diodes 331 and 332 of the phase-shifting means 330 and the input capacitance of the capacitor 333 are set so that the phase differences are substantially the same value at the optimum drive frequency f0.

Therefore, if the target phase difference set by the comparison voltage setting circuit 350 is set in advance to the phase difference (140°) between the shifted detection signal SD1a and the drive voltage signal SDR at the optimum drive frequency f0, then there is no need to vary the target phase difference even if the drive voltage fluctuates, and the piezoelectric actuator A can be controlled at the optimum drive frequency by being compared with this constant target phase difference.

### [3-2. Another configuration of drive control apparatus for piezoelectric actuator A]

The phase-shifting means 330 is not limited to the configuration described above, and a configuration in which a MOS transistor 334 is used as a nonlinear element can also be employed, as shown in FIG. 10.

In this case, a MOS transistor 334 in an off state can be used as the nonlinear element of the phase-shifting means 330, or the parasitic diode 334A of the MOS transistor 334 may be used.

In cases in which a MOS transistor 334 in an off state is used, the threshold voltage VTH of the MOS transistor 334 can be set in advance below the threshold voltage VF of the parasitic diode 334A.

Also, in cases in which the parasitic diode 334A is used, the threshold voltage VF of the parasitic diode 334A can be set in advance below the threshold voltage VTH of the MOS transistor 334. The phase of the detection signal SD1 can be shifted by a phase-shifting means 330 in which the MOS transistor 334 is used in the same manner as in the previous description.

Furthermore, the parasitic capacitance of a MOS transistor can be used instead of the capacitor 333, and the capacitor 333 can be omitted by optimizing the size and other features of the MOS transistor.

### [3-3. Drive control method for piezoelectric actuator A]

The drive control method for the piezoelectric actuator A in which the drive control apparatus 300 of the present embodiment is used is substantially similar to the above-described drive control method of the first example, and differs in that step S1 for detecting the power-source voltage (drive voltage) in FIG. 5 is omitted, the phase of the detection signal SD1 is shifted in step S2, and steps S2 and S5 are repeated after steps S6A and S6B. Specifically, after driving is initiated and the signal generating frequency is set to a preset maximum frequency fmax (step S3), the phase of the detection signal SD1 is automatically shifted by the phase-shifting means 330 in accordance with the power-source voltage (drive voltage) (step S2), the phase difference between the phase-shifted detection signal SD1a and the drive voltage signal SDR is compared with the target phase difference (step S5), and the signal generating frequency is either reduced or increased on the basis of these comparison results (steps S6A, S6B). Sequentially repeating these steps S2, S5, S6A, and S6B implements feedback control, whereby the drive voltage signal SDR reaches a drive frequency in the vicinity of the optimum drive frequency f0, and the vibrating state of the vibrator 12 is controlled in an optimal manner.

### [3-4. Effects of the embodiment]

In the embodiment described above, the following effects are obtained in addition to the effects described above in (2) and (4) through (7).
(10) Specifically, the drive frequency can be varied rapidly because the phase of the detection signal SD1 is shifted by the phase-shifting means 330 in accordance with the drive voltage, and feedback control is performed based on the comparison between the target phase difference and the phase difference of the shifted detection signal SD1a and the drive voltage signal SDR. Specifically, control can be rapidly and reliably implemented because the phase of the detection signal SD1 can be immediately shifted according to the fluctuation in drive voltage.

(11) Furthermore, in cases in which the power-source voltage decreases or becomes nonuniform because of the specific service conditions, service period, or other parameters of the electronic timepiece 1, shifting the phase of the detection signal SD1 according to the power-source voltage during feedback control of the piezoelectric actuator A makes it possible to implement drive control in which the effects of voltage fluctuation are avoided and the drive efficiency of the piezoelectric actuator A can always be appropriately maintained.

(12) Also, the circuit configuration of the drive control apparatus 300 can be simplified by configuring the phase-shifting means 330 with the diodes 331 and 332, the capacitor 333, and the MOS transistor 334. Furthermore, if the diodes 331 and 332 are also used as electrostatic preserving diodes, the circuit configuration can be further simplified. In cases in which the vibration detecting electrode T1 of the piezoelectric actuator A is used in place of the drive electrode, the circuitry can be further simplified by using a drive transistor as the MOS transistor of the phase-shifting means 330.

### [4. Third example]

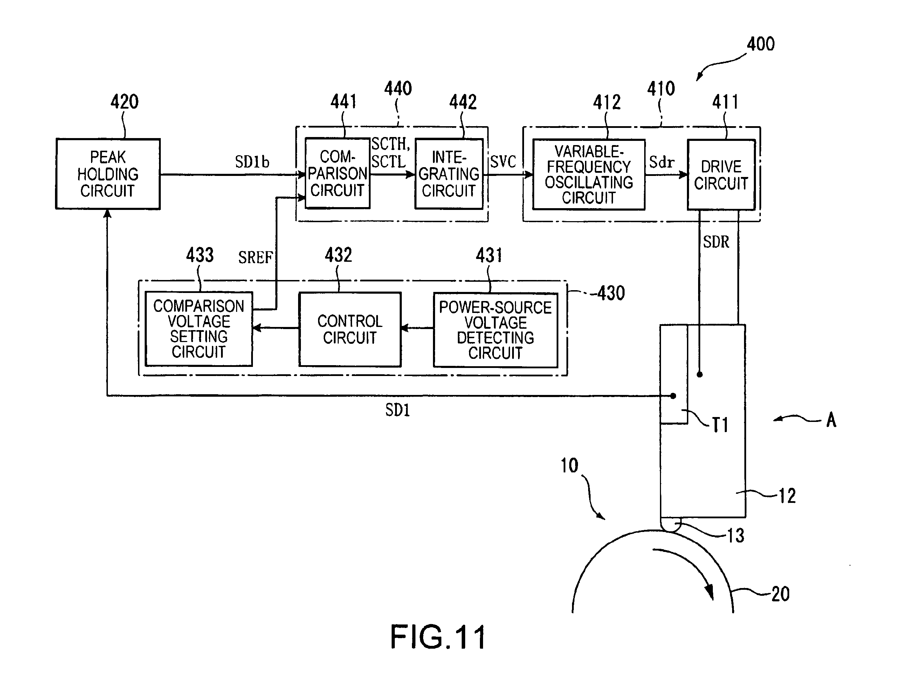

Next, a third example will be described with reference to FIG. 11.

FIG. 11 is a block diagram showing the drive control apparatus 400 of the present embodiment.

The third example relates to an electronic timepiece 1 having the same configuration as the above-described first and second examples and embodiment. The timepiece differs in terms of the drive control apparatus 400 of the piezoelectric actuator A for driving the date display mechanism 10.

Specifically, in the first and second examples and the embodiment, feedback control was implemented in which the phase difference between the detection signal SD1 and the drive voltage signal SDR expressing the vibrating state of the piezoelectric actuator A was compared with a target phase difference, which was the target value of the vibrating state, and the drive frequency of the drive voltage signal SDR was varied based on the comparison result.

The third example differs in that the electric voltage or current value of the detection signal SD1 is detected as a value expressing the vibrating state of the piezoelectric actuator A, the detected electric voltage or current value is compared with a target value (target electric voltage or current), and feedback control is performed based on the comparison result. The differences are described in detail hereinbelow.

### [4-1. Configuration of drive control apparatus of piezoelectric actuator A]

In FIG. 11, the drive control apparatus 400 includes drive signal supply means 410, a peak holding circuit 420 as voltage detection means for detecting the voltage value of the detection signal SD1, correction means 430 for correcting the target voltage, which is the target value, and drive frequency setting means 440 as comparison means for comparing the detected voltage value and a comparison voltage.

The drive signal supply means 410 and the drive frequency setting means 440 herein have the same configuration as the drive signal supply means 110, 210, and 310 and the drive frequency setting means 140, 240, and 340 of the first and second examples and the embodiment. The drive signal supply means 410 includes a drive circuit 411 and a variable-frequency oscillating circuit 412, and the drive frequency setting means 440 includes a comparison circuit 441, an integrating circuit 442, and a drive control circuit as control means (not shown).

The peak holding circuit 420 is configured from an operational amplifier or a voltage-holding capacitor, and is designed to detect the voltage value of the detection signal SD1 from the vibration detecting electrode T1 of the vibrator 12, to retain this voltage value, and to output the retained voltage value as a voltage signal SD1b to the drive frequency setting means 440.

The correction means 430 is a circuit that sets the target comparison voltage (target voltage) in accordance with the target value and outputs a comparison voltage signal SREF equivalent to the comparison voltage to the drive frequency setting means 440. Specifically, when the drive voltage has fluctuated, the correction means varies the comparison voltage according to this fluctuation. The correction means 430 includes a power-source voltage detecting circuit 431 for detecting the power-source voltage (drive voltage), a control circuit 432 for varying the comparison voltage according to the power-source voltage detected by the power-source voltage detecting circuit 431, and a comparison voltage setting circuit 433 as voltage variation means (target value setting means) for varying the comparison voltage as instructed by the power-source voltage detecting circuit 431, and outputting a comparison voltage signal SREF equivalent to the varied comparison voltage to the drive frequency setting means 440. The control circuit 432 presents the comparison voltage setting circuit 433 with a control signal that corresponds to the power-source voltage detected by the power-source voltage detecting circuit 431.

The comparison voltage setting circuit 433 includes an up-down counter and a D/A converter (neither are shown) in the same manner as in the comparison voltage setting circuit 133 in the above-described first example, and is a circuit that presents the drive frequency setting means 440 with a comparison voltage signal SREF equivalent to the set comparison voltage while being controlled by the control circuit 432.

The power-source voltage detecting circuit 431 is not limited to detecting the power-source voltage (drive voltage), may be connected to the vibration detecting electrode T1 of the vibrator 12 of the piezoelectric actuator A, and may be configured so as to detect the voltage value of the detection signal SD1 from the vibration detecting electrode T1.

The drive frequency setting means 440 inputs a voltage signal SD1b from the peak holding circuit 420 as well as a comparison voltage signal SREF that is equivalent to the comparison voltage set by the comparison voltage setting circuit 433 of the correction means 430, and drive control is performed wherein the drive frequency of the drive voltage signal SDR outputted from the drive signal supply means 410 is locked in the vicinity of the optimum drive frequency f0 for the selected design so that that the difference between the voltage signal SD1b and the comparison voltage signal SREF is close to zero.

### [4-2. Another configuration of drive control apparatus of piezoelectric actuator A]

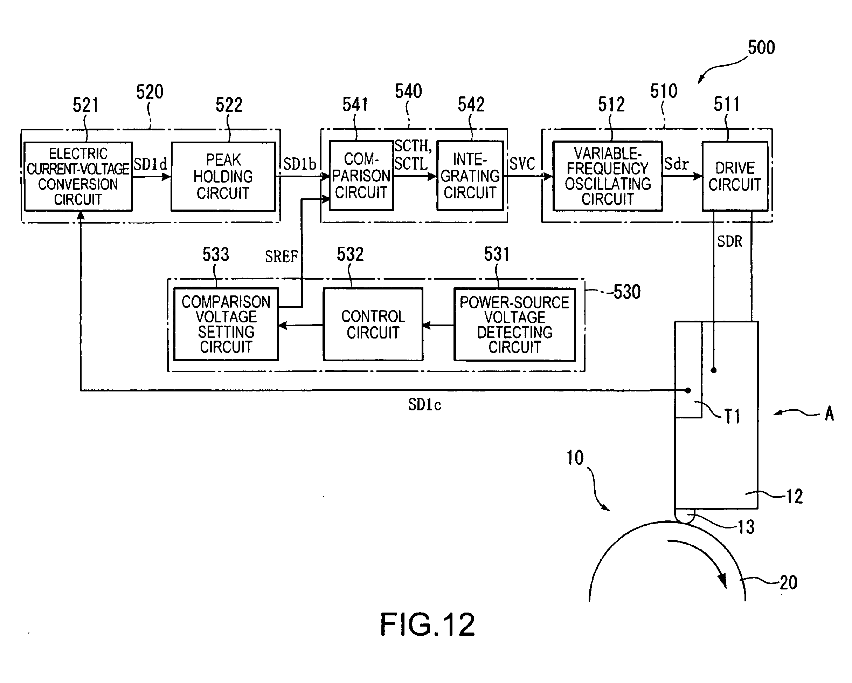

The value expressing the vibrating state of the piezoelectric actuator A is not limited to the voltage value of the detection signal SD1 and may also be the electric current value of the detection signal SD1, and a drive control apparatus 500 that includes electric current detection means for detecting an electric current value can be employed, as shown in FIG. 12.

FIG. 12 is a block diagram showing the drive control apparatus 500 as another configuration of the present example.

In FIG. 12, the drive control apparatus 500 includes drive signal supply means 510; electric current detection means 520 for detecting the electric current of the detection signal SD1; correction means 530 for correcting the target electric current (comparison electric current), which is the target value; and drive frequency setting means 540 as comparison means for comparing the detected electric current value and a comparison electric current.

The drive signal supply means 510 and the drive frequency setting means 540 have the same configuration as the above-described drive signal supply means 410 and drive frequency setting means 440; the drive signal supply means 510 includes a drive circuit 511 and a variable-frequency oscillating circuit 512; and the drive frequency setting means 540 includes a comparison circuit 541, an integrating circuit 542, and a drive control circuit as comparison means (not shown).

The electric current detection means 520 detects the electric current value (SD1c) of the detection signal SD1 from the vibration detecting electrode T1 of the vibrator 12, converts this electric current value into a voltage value and maintains it as a voltage value, and outputs the maintained voltage value as a voltage signal SD1b to the drive frequency setting means 540. This electric current detection means 520 includes an electric current-voltage conversion circuit 521 for converting the electric current value of the detection signal SD1 into a voltage value, and a peak holding circuit 522. The electric current-voltage conversion circuit 521 converts the detected electric current value SD1c into a voltage signal SD1d and outputs the voltage signal to the peak holding circuit 522. The peak holding circuit 522 is similar to the above-described peak holding circuit 420.

The correction means 530 is a circuit that sets the target comparison electric current (target electric current) in accordance with the target value and presents the drive frequency setting means 540 with a comparison voltage signal SREF equivalent to the comparison electric current. Specifically, when the drive voltage has fluctuated, the correction means varies the comparison electric current according to this fluctuation. The correction means 530 includes a power-source voltage detecting circuit 531 similar to the one previously described, a control circuit 532, and a comparison voltage setting circuit 533 as electric current variation means (target value setting means) for varying the comparison electric current as instructed by the control circuit 532, and presenting the drive frequency setting means 540 with a comparison voltage signal SREF in which the varied comparison electric current has been converted to voltage. The comparison voltage setting circuit 533 is a circuit that presents the drive frequency setting means 540 with a comparison voltage signal SREF equivalent to the set comparison electric current while being controlled by the control circuit 532 in the same manner as in the above-described comparison voltage setting circuit 433.

The power-source voltage detecting circuit 531 is not limited to detecting the power-source voltage (drive voltage), may be connected to the vibration detecting electrode T1 of the vibrator 12 of the piezoelectric actuator A, and may be configured so as to detect the voltage value of the detection signal SD1 from the vibration detecting electrode T1.

### [4-3. Another configuration of drive control apparatus of piezoelectric actuator A]

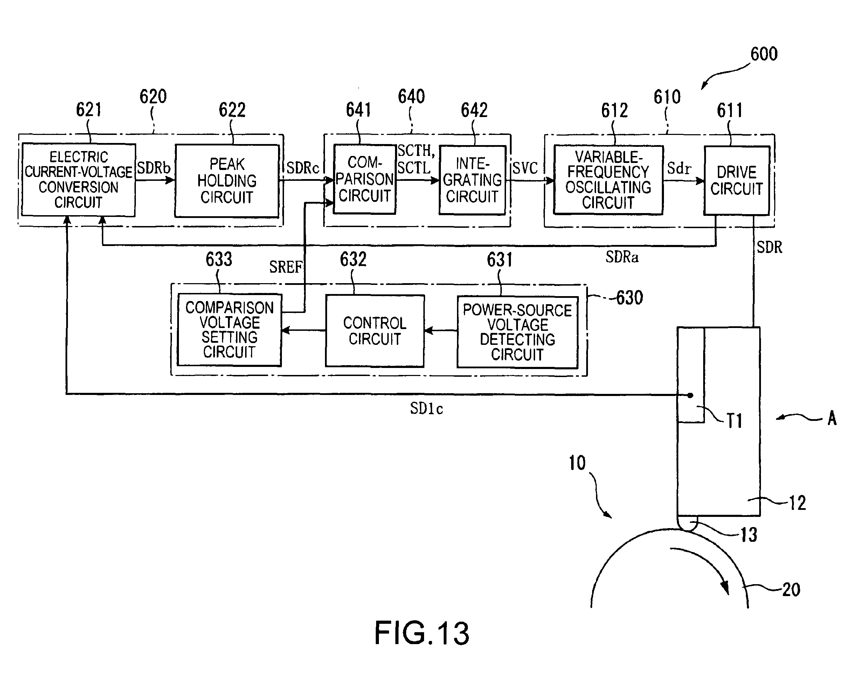

The value expressing the vibrating state of the piezoelectric actuator A is not limited to the electric current value of the detection signal SD1 and may also be the electric current value of the drive voltage signal SDR. A drive control apparatus 600 that includes electric current detection means for detecting an electric current value can be employed, as shown in FIG. 13.

FIG. 13 is a block diagram showing the drive control apparatus 600 as another configuration of the present example.

In FIG. 13, the drive control apparatus 600 includes drive signal supply means 610; electric current detection means 620 for detecting the electric current value of the drive voltage signal SDR; correction means 630 for correcting the target electric current (comparison electric current), which is the target value; and drive frequency setting means 640 as comparison means for comparing the detected electric current value and a comparison electric current.

The drive signal supply means 610 and the drive frequency setting means 640 have the same configuration as the drive signal supply means 410 and 510 and the drive frequency setting means 440 and 540 previously described; the drive signal supply means 610 includes a drive circuit 611 and a variable-frequency oscillating circuit 612; and the drive frequency setting means 640 includes a comparison circuit 641, an integrating circuit 642, and a drive control circuit as comparison means (not shown).

The electric current detection means 620 detects the electric current value (SDRa) of the drive voltage signal SDR from the drive circuit 611, converts this electric current value into a voltage value and maintains it as a voltage value, and outputs the maintained voltage value as a voltage signal SDRc to the drive frequency setting means 640. This electric current detection means 620 includes an electric current-voltage conversion circuit 621 for converting the electric current value of the drive voltage signal SDR into a voltage value, and a peak holding circuit 622. The electric current-voltage conversion circuit 621 converts the detected electric current value SDRa into a voltage signal SDRb and outputs the voltage signal to the peak holding circuit 622. The peak holding circuit 622 is similar to the above-described peak holding circuits 420 and 520.

The correction means 630 is the same as in the above-described correction means 530, and is a circuit that sets the target comparison electric current (target electric current) in accordance with the target value and outputs a comparison voltage signal SREF equivalent to the comparison electric current to the drive frequency setting means 640. The correction means 630 includes a power-source voltage detecting circuit 631 similar to the one previously described, a control circuit 632, and a comparison voltage setting circuit 633. The comparison voltage setting circuit 633 is a circuit that presents the drive frequency setting means 640 with a comparison voltage signal SREF equivalent to the set comparison electric current while being controlled by the control circuit 632 in the same manner as in the above-described comparison voltage setting circuits 433 and 533.

### [4-4. Drive control method for piezoelectric actuator A]

The drive control method for a piezoelectric actuator A in which the drive control apparatuses 400, 500, and 600 of the present example are used is substantially similar to the above-described drive control method of the first example, and differs in that the comparison voltage (or electric current) is varied in step S2 in FIG. 5, and the voltage signals SD1b and SDRc outputted from the peak holding circuits 420, 522, and 622 are compared with the comparison voltage signal SREF from the comparison voltage setting circuits 433, 533, and 633 in step S5. Specifically, the drive voltage is detected by the power-source voltage detecting circuits 431, 531, and 631 when driving is initiated (step S1); the comparison voltage (or electric current) is varied by the comparison voltage setting circuits 433, 533, and 633 on the basis of the detected power-source voltage (step S2); the oscillation frequency is set to a preset maximum frequency fmax (step S3); the voltage signals SD1b and SDRc from the peak holding circuits 420, 522, and 622 are compared with the comparison voltage signal SREF (step S5); and the oscillation frequency is reduced or increased based on the comparison result (steps S6A and S6B). Sequentially repeating these steps S5, S6A, and S6B implements feedback control, whereby the drive voltage signal SDR reaches a drive frequency in the vicinity of the optimum drive frequency f0, and the vibrating state of the vibrator 12 is controlled in an optimal manner.

Steps S1, S2, and S5 may be repeated after steps S6A and S6B are complete. In this case, the power-source voltage can be detected as needed by the power-source voltage detecting circuits 431, 531, and 631, and the comparison voltage (or electric current) can be reset by the comparison voltage setting circuits 433, 533, and 633 on the basis of the power-source voltage, each time the steps are repeated. It is therefore, possible to correct any deviations between the voltage value (or electric current value) of the detection signal SD1 and the comparison voltage (or electric current), or between the electric current value of the drive voltage signal SDR and the comparison voltage brought about by fluctuations in the power-source voltage.

### [4-4. Effects of the third example]

In the second example described above, the following effects are obtained in addition to the effects described above in (2), (5), and (7).
(13) Specifically, feedback control is performed in which the comparison voltage (or electric current) is corrected by the comparison voltage setting circuits 433, 533, and 633 on the basis of the power-source voltage detected by the power-source voltage detecting circuits 431, 531, and 631; a comparison is made between the corrected comparison voltage (or electric current) and the voltage value (or electric current value) of the detection signal SD1 or the voltage value of the drive voltage signal SDR; and the drive frequency of the drive voltage signal SDR is varied based on the comparison result. As a result of feedback control, drive control for the piezoelectric actuator A is performed in which the relationship between the vibrating state and the target value thereof can be properly modified and the optimum drive frequency can be applied to achieve highly efficient driving even in cases in which the vibrating state of the vibrator 12 deviates from the target value in accordance with its dependence on the power-source voltage.

(14) Furthermore, in cases in which the power-source voltage decreases or becomes nonuniform because of the specific service conditions, service period, or other parameters of the electronic timepiece 1, detecting the power-source voltage during the drive start and the feedback control of the piezoelectric actuator A and resetting the comparison voltage (or electric current) on the basis of this voltage will make it possible to implement drive control in which the effects of voltage fluctuation are avoided and the drive efficiency of the piezoelectric actuator A can always be appropriately maintained.

### [5. Second embodiment]

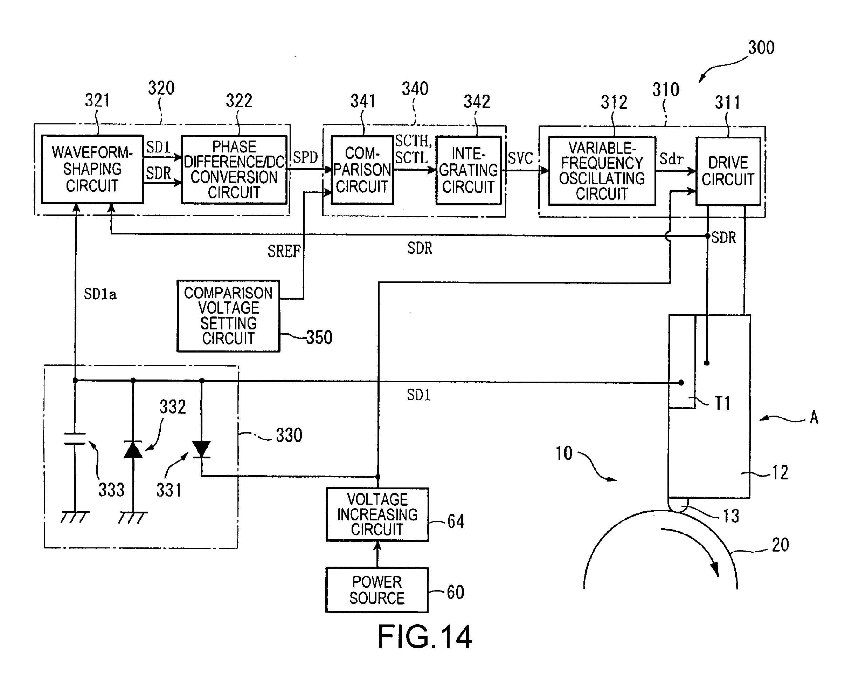

Next, a second embodiment of the present invention will be described with reference to FIGS. 14 through 17.

The drive control apparatus 300 of the piezoelectric actuator A in the present embodiment is similar to that of the above-described first embodiment, and detailed descriptions thereof are omitted.

### [5.1 Configuration of power source and drive control apparatus of piezoelectric actuator A]

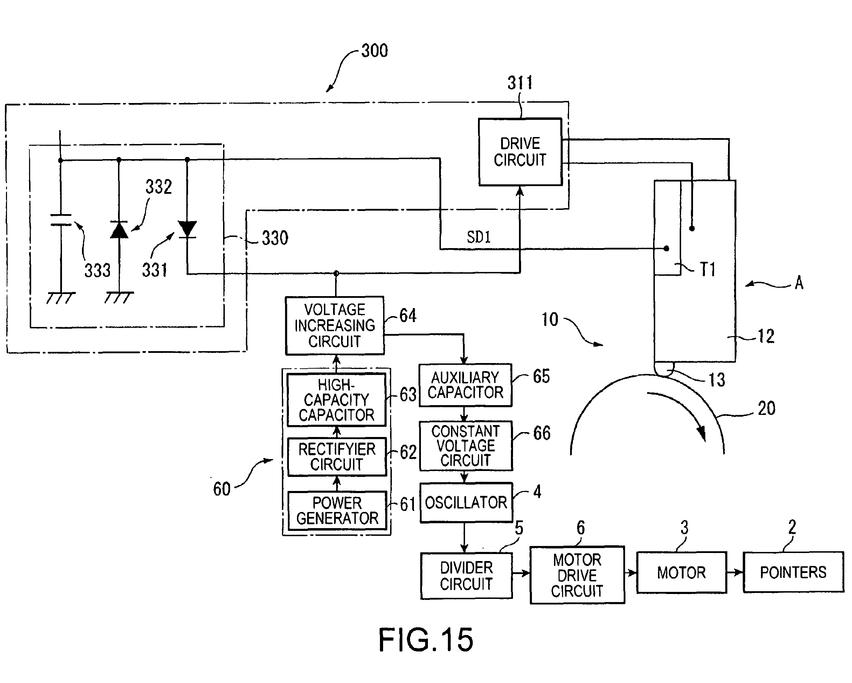

FIG. 14 is a block diagram showing the configuration of the power source 60 and the drive control apparatus 300 in the electronic timepiece 1 of the present embodiment. FIG. 15 is a block diagram showing the drive unit, the power source 60, and the drive control apparatus 300 of the electronic timepiece 1, depicting the area around the power source 60 in FIG. 14 in greater detail.

In FIGS. 14 and 15, the power source 60 of the electronic timepiece 1 is connected via a voltage increasing circuit 64 with a diode 331 of the phase-shifting means 330 in the drive control apparatus 300, and with a drive circuit 311 of the drive signal supply means 310. The power source 60 has a power generator 61, a rectifier circuit 62, and a high-capacity capacitor 63, as shown in FIG. 15. A power generating device based on a solar battery or an oscillating weight, a power generating device that is driven by a mainspring, or another such power generating device can be used as the power generator 61, and the output from the power generator 61 is used to charge the high-capacity capacitor 63 after being rectified by the rectifier circuit 62 that operates on the principle of step-up rectification, full-wave rectification, half-wave rectification, transistor rectification, and the like. In cases in which a solar battery that generates direct-current electricity is used as the power generator 61, the rectifier circuit 62 may be omitted, and the solar battery may be connected to the high-capacity capacitor 63 via a backflow prevention circuit. A drive voltage, obtained by a process in which the power-source voltage charged to the high-capacity capacitor 63 is boosted by the voltage increasing circuit 64, is then applied to the diode 331 and the drive circuit 311 of the piezoelectric actuator A. Thus, the drive voltage is applied via the high-capacity capacitor 63 and the voltage increasing circuit 64, whereby a drive voltage boosted by the voltage increasing circuit 64 can be applied to the piezoelectric actuator A, and the piezoelectric actuator A can be driven even more efficiently in accordance with the configuration of the above-described drive control apparatus 300.

The power-source voltage boosted by the voltage increasing circuit 64 is temporarily charged to an auxiliary capacitor 65, and the power-source voltage thus charged is then applied via a constant voltage circuit 66 to an oscillator 4, a divider circuit 5, a drive circuit 6, and a stepping motor 3, which are the drive units of the electronic timepiece 1. Thus, the power-source voltage boosted by the voltage increasing circuit 64 is applied to the oscillator 4 via the auxiliary capacitor 65 and the constant voltage circuit 66, whereby the oscillation frequency of the reference pulse outputted from the oscillator 4 can be stabilized. A stable voltage can then be supplied to the drive units of the electronic timepiece 1, and the movement of the pointers 2 can be stabilized because the power-source voltage applied to the oscillator 4 is less susceptible to the effects of the drive load of the date display mechanism 10. Specifically, the 24 hour detection switch 8 acts as a trigger for the operation of the date display mechanism 10 of the electronic timepiece 1 driven by the piezoelectric actuator A as previously described, and the date display mechanism is stopped after the date wheel 50 has rotated the amount equivalent to one day. Therefore, the load on the power source 60 increases during operation of the date display mechanism 10, but a stable voltage can be applied to the drive units of the electronic timepiece 1 via the auxiliary capacitor 65 and the constant voltage circuit 66.

### [5-2. Another configuration of power source and drive control apparatus of piezoelectric actuator A]

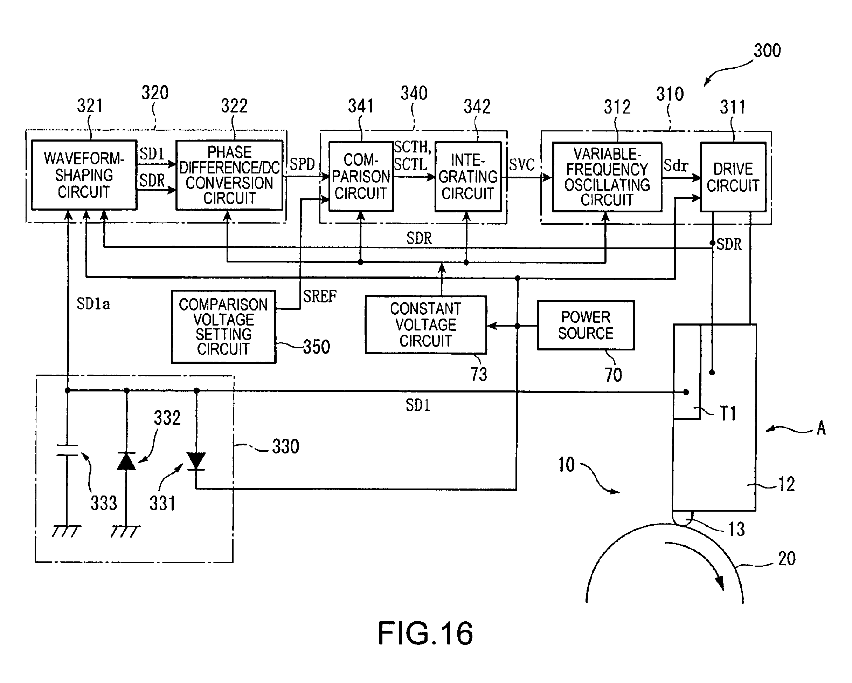

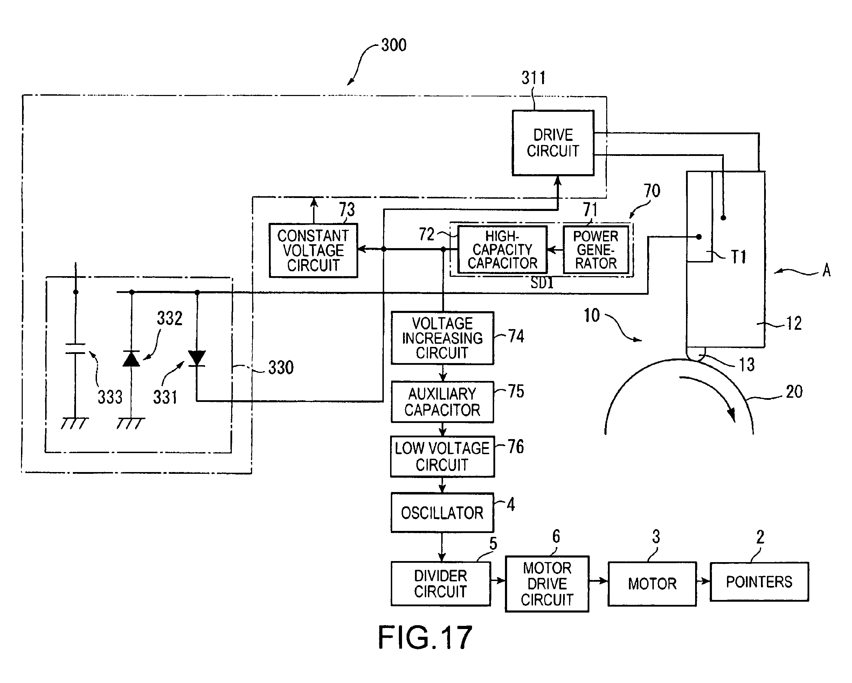

The configuration of the power source and of the drive control apparatus of the piezoelectric actuator A is not limited to the one described above, and the configuration shown in FIGS. 16 and 17 can also be employed.

FIG. 16 is a block diagram showing another configuration of a power source 70 and the drive control apparatus 300 according to the present embodiment. FIG. 17 is a block diagram showing the drive units of the electronic timepiece 1, the power source 60, and the drive control apparatus 300 of this configuration, depicting the area around the power source 70 in FIG. 16 in greater detail.

In FIGS. 16 and 17, the power source 70 of the electronic timepiece 1 is connected to a diode 331 of the phase-shifting means 330 in the drive control apparatus 300, a drive circuit 311 of the drive signal supply means 310, and a waveform-shaping circuit 321 of a phase difference detection means 320. The power source 70 is also connected via a constant voltage circuit 73 to a phase difference/DC conversion circuit 322 of the phase difference detection means 320, a comparison circuit 341 and an integrating circuit 342 of a drive frequency setting means 340, and a variable-frequency oscillating circuit 312 of the drive signal supply means 310. The power source 70 has a power generator 71 and a high-capacity capacitor 72, as shown in FIG. 17, and alternating-current output from the power generator 71 is used to charge the high-capacity capacitor 72. The power-source voltage charged to the high-capacity capacitor 72 is then applied to the circuits 322, 341, 342, and 312 of the drive control apparatus 300 via the constant voltage circuit 73.

The power-source voltage charged to the high-capacity capacitor 72 is temporarily charged to an auxiliary capacitor 75 after being increased by the voltage increasing circuit 74 in the same manner as in FIG. 15 above, and the power-source voltage thus charged is then applied via a constant voltage circuit 76 to an oscillator 4, a divider circuit 5, a drive circuit 6, and a stepping motor 3, which are the drive units of the electronic timepiece 1. The oscillation frequency of the reference pulse outputted from the oscillator 4 can thereby be stabilized in the same manner as in the previous description.

### [6. Fourth example and third embodiment]

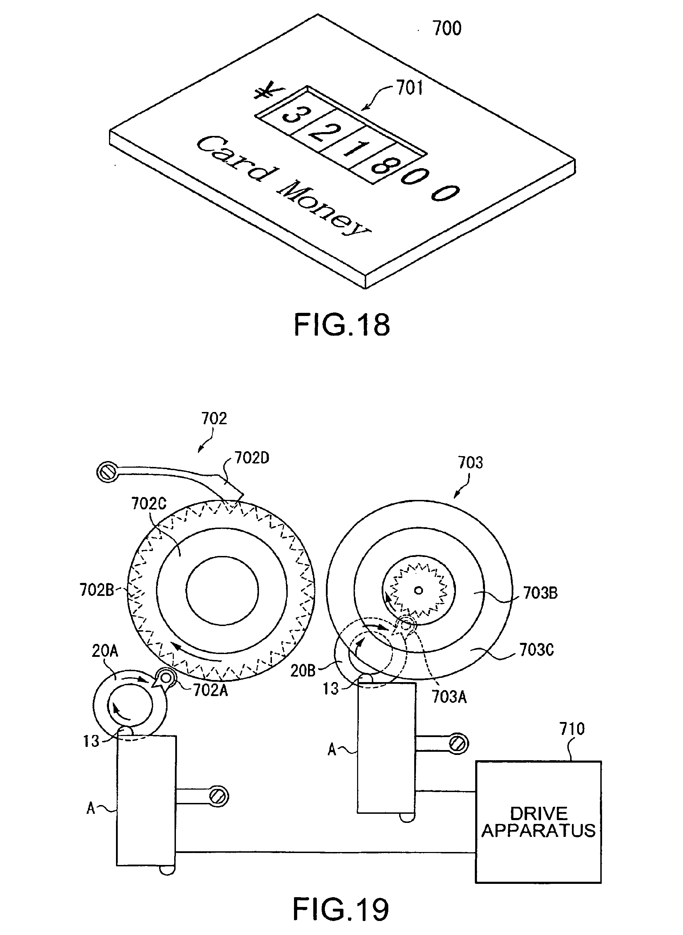

Next, a fourth example and third embodiment will be described with reference to FIGS. 18 and 19.

The present example and embodiments differs from the first through third examples and the embodiments in that the drive control apparatuses 100, 200, 300, 400, 500, and 600 are used in portable electronic devices, but the configuration of the drive apparatus for the piezoelectric actuator is the same in any of the above examples and embodiments. In the description of the fourth example and third embodiment, structural components that are similar to those in the previous examples and embodiments are denoted by the same numerical symbols, and descriptions thereof are omitted or simplified.

### [6-1. Configuration of electronic device]

In the present example and embodiment, the electronic device (portable device) is a noncontact IC card 700 having a payment function, and this IC card 700 is provided with a piezoelectric actuator A and a drive apparatus 710.

FIG. 18 is an external perspective view of the noncontact IC card 700.

In FIG. 18, a remaining balance display counter 701 for displaying the remaining balance is disposed in the surface of the noncontact IC card 700.

The remaining balance display counter 701 displays the remaining balance in four digits, and includes an upper digit display section 702 for displaying the upper two digits, and a lower digit display section 703 for displaying the lower two digits, as shown in FIG. 19.

The upper digit display section 702 is linked to the piezoelectric actuator A via a rotor 20A, and is driven by the driving force of the rotor 20A. The main section of the upper digit display section 702 includes a drive gear 702A that has urging teeth and that rotates once when the rotor 20A rotates 1/n times, a first upper digit display wheel 702B that rotates by one graduation when the drive gear 702A rotates once, a second upper digit display wheel 702C that turns by one graduation when the first upper digit display wheel 702B rotates once, and a fixing member 702D for fixing the first upper digit display wheel 702B in place when the first upper digit display wheel 702B is not rotating. The second upper digit display wheel 702B is also provided with a fixing member (not shown) for fixing the second upper digit display wheel 702C in place.

The drive gear 702A rotates once when the rotor 20A rotates 1/n times. The urging teeth of the drive gear 702A mesh with the urging gear section of the first upper digit display wheel 702B, and the first upper digit display wheel 702B is rotated by one graduation. Furthermore, when the first upper digit display wheel 702B rotates once, an urging pin provided to the first upper digit display wheel 702B rotates the urging gear, an urging gear of the second upper digit display wheel 702C is also rotated, and the second upper digit display wheel 702C is rotated by one graduation.

The lower digit display section 703 is linked to the piezoelectric actuator A via a rotor 20B, and is driven by the driving force of the rotor 20B. The main section of the lower digit display section 703 includes a drive gear 703A that has urging teeth and that rotates once when the rotor 20B rotates 1/n times, a first lower digit display wheel 703B that turns by one graduation when the drive gear 703A rotates once, and a second lower digit display wheel 703C that turns by one graduation when the first lower digit display wheel 703B rotates once.

The first lower digit display wheel 703B has an urging gear that meshes with the urging teeth of the drive gear 703A and turns by one graduation when the drive gear 703A rotates once. The first lower digit display wheel 703B is provided with an urging pin, which rotates the urging gear and also turns the second lower digit display wheel 703C by one graduation every time the first lower digit display wheel 703B rotates once. In this case, the fixing members (not shown) of the first lower digit display wheel 703B and the second lower digit display wheel 703C mesh with the corresponding urging gears and fix the first lower digit display wheel 703B and the second lower digit display wheel 703C in place when they are not rotating.

In the noncontact IC card 700 described above, the actuator A is set so as to be driven synchronously by the drive apparatus 710, and the drive apparatus 710 is driven by the input of a drive control signal that corresponds to a settlement figure being inputted by an IC card chip (not shown). The specific structure of the drive apparatus 710 is the same as the drive control apparatuses 100, 200, 300, 400, 500, and 600 in all the previous examples and the embodiments, so descriptions thereof are omitted.

Such a configuration allows even a thin portable device such as a noncontact IC card to mechanically display the remaining balance, and the information to be displayed without the need for a power source during periods in which driving is not performed. Therefore, data can be displayed with low product power, and the current display can be maintained even when the power source has expired.

### [7. Modifications of the examples and the embodiments]

Modifications as described in the following can be applied to the examples and the embodiments, with the present invention being defined by the claims.

For example, in t e previous examples and embodiments, an electronic timepiece 1, or a wristwatch, and noncontact IC card 700 were described, but the electronic timepiece is not limited to a wristwatch and may also be a standing clock or a wall clock. Also, the electronic device is not limited to an electronic timepiece or an IC card. The present invention can be applied to various electronic devices and is particularly suitable for portable electronic devices that require size reduction. Possible examples of the various electronic devices include phones, portable phones, personal computers, personal digital assistants (PDA), cameras, and other devices that include a timepiece function. The present invention can also be applied to electronic devices that do not include a timepiece function, such as cameras, digital cameras, video cameras, and camera phones. When the present invention is applied to an electronic device with a camera function, the piezoelectric actuator of the present invention can be used to drive the focusing mechanism for the lens, the zoom mechanism, the aperture adjusting mechanism, or the like. Furthermore, the piezoelectric actuator of the present invention may be used as a drive mechanism for meter pointers in a measuring device, or a drive mechanism for mobile toys.

Also, in the previous examples and embodiments, the piezoelectric actuator A was used for driving the date display mechanism 10 of the electronic timepiece 1, but the present invention is not limited thereto, and the time display hands (pointers) of the electronic timepiece 1 may also be driven by the piezoelectric actuator A. Thus, replacing the stepping motor 3 for driving the pointers with the piezoelectric actuator A makes it possible to further reduce the thickness of the electronic timepiece, and also makes it possible to ensure that the electronic timepiece will be highly antimagnetic because the piezoelectric actuator A is less susceptible to the effects of magnetism than the stepping motor.

Furthermore, in the present invention, all the devices within the drive control apparatuses 100, 200, 300, 400, 500, and 600 are configured from various logical circuit elements and other such hardware, but functionality of the present invention may also be configured so that the means are emulated by mounting a computer with a CPU (central processing unit) and memory (storage apparatus) in the electronic device, and incorporating specific programs and data (data stored in the storage units) into the computer.

The programs and data may be stored in advance in RAM, ROM, or another type of memory incorporated into the electronic device. Also, for example, a specific control program and data may be installed in the electronic device via the Internet or another such communication means, or a CD-ROM, memory card, or other such recording medium. The devices may be implemented by operating the CPU or the like with a program stored in the memory. Specific programs and the like may be installed in a timepiece or portable device by directly inserting a memory card or a CD-ROM into the timepiece or portable device, or by externally connecting a device for reading these recording media to the timepiece or portable device. Furthermore, a LAN cable, a phone line, or the like may be connected to the timepiece or portable device to load and install the programs by communication, or the programs may be supplied and installed wirelessly.

### INDUSTRIAL APPLICABILITY

The present invention can be used in an apparatus for driving a piezoelectric actuator, in an electronic device, in a drive method for an electronic device, in a drive control program for an electronic device, and in a recording medium on which this program is recorded.

## Claims

1. An apparatus (300) for driving a piezoelectric actuator (A) having a vibrator (12) that vibrates due to the application of a drive signal (SDR) having a prescribed drive frequency to a piezoelectric element; said apparatus (300) for driving a piezoelectric actuator (A) comprising:
drive means (310) for supplying the drive signal (SDR) to the piezoelectric element of the vibrator (12);
phase-shifting means (330) for correcting a phase of a detection signal (SD1) indicating the vibrating state of the vibrator (12) based on the voltage of the detection signal (SD1);
phase difference detection means (320) for detecting a phase difference between the drive signal (SDR) and the detection signal (SD1a) whose phase has been corrected by the phase-shifting means (330);
comparison means (340) for comparing the phase difference detected by the phase difference detection means (320) and a target phase difference for optimizing the drive frequency of the vibrator; and
control means for varying the drive frequency of the drive signal on the basis of the comparison results from the comparison means (340) so that the phase difference detected by the phase difference detection means (320) is brought closer to the target phase difference after said target phase difference and said phase difference detected by the phase difference detection means (320) are compared by said comparison means (340).

2. The apparatus (300) for driving a piezoelectric actuator (A) according to claim 1, **characterized in that**:
the phase-shifting means is configured from a nonlinear element.

3. The apparatus (300) for driving a piezoelectric actuator (A) according to claim 2, **characterized in that**:
the nonlinear element is a diode.

4. The apparatus (300) for driving a piezoelectric actuator (A) according to claim 3, **characterized in that**:
the diode is the parasitic diode of a MOS transistor.

5. The apparatus (300) for driving a piezoelectric actuator (A) according to claim 2, **characterized in that**:
the nonlinear element is a transistor in an off state.

6. The apparatus (300) for driving a piezoelectric actuator (A) according to claim 1, **characterized in that**:
the phase-shifting means includes a capacitor or a parasitic capacitance of a MOS transistor and at least one of a diode, parasitic diode of a MOS transistor and a transistor in an off state, and
the phase-shifting means (330) is adapted to correct the phase of the detection signal to a corrected phase when a voltage of said detection signal is more than a threshold voltage of at least one of the diode, parasitic diode of a MOS transistor and transistor in an off state.

7. An electronic device, **characterized by** comprising the apparatus (300) for driving a piezoelectric actuator (A) according to any of claims 1 through 6, a piezoelectric actuator (A) driven by this apparatus (300), and a power source.

8. A method for driving an electronic device comprising a piezoelectric actuator (A) having a vibrator (12) that vibrates due to the application of a drive signal (SDR) having a prescribed drive frequency to a piezoelectric element, drive means (310) for supplying the drive signal to the piezoelectric element of the vibrator (12), and a power source; said electronic device drive method comprising:
a phase-shifting step of correcting a phase of a detection signal (SD1) indicating the vibrating state of the vibrator (12) based on the voltage of the detection signal (SD1);
a phase difference detection step of detecting a phase difference between the drive signal (SDR) and the detection signal (SD1a) whose phase has been corrected in the phase shifting step;
a comparison step of comparing the phase difference detected in the phase difference detection step and a target phase difference for optimizing the drive frequency of the vibrator after the phase of the detection signal has been corrected in the phase-shifting step; and
a control step of varying the drive frequency of the drive signal on the basis of the comparison results from the comparison step so that the phase difference detected in the phase difference detection step is brought closer to the target phase difference after said target phase difference and said phase difference detected in the phase difference detection step are compared in said comparison means.

## Patentansprüche

1. Einrichtung (300) zum Ansteuern eines piezoelektrischen Stellgliedes (A) mit einem Vibrator (12), der aufgrund des Anlegens eines Ansteuersignals (SDR) mit einer vorgeschriebenen Ansteuerfrequenz an ein piezoelektrisches Element vibriert; wobei die Einrichtung (300) zum Ansteuern eines piezoelektrischen Stellgliedes (A) umfasst:
ein Ansteuermittel (310) zum Zuleiten des Ansteuersignals (SDR) zu dem piezoelektrischen Element des Vibrators (12);
ein Phasenverschiebungsmittel (330) zum Korrigieren einer Phase eines Detektionssignals (SD1), das den vibrierenden Zustand des Vibrators (12) anzeigt, auf der Basis der Spannung des Detektionssignals (SD1);
ein Phasendifferenzdetektionsmittel (320) zum Detektieren einer Phasendifferenz zwischen dem Ansteuersignal (SDR) und dem Detektionssignal (SD1a), dessen Phase durch das Phasenverschiebungsmittel (330) korrigiert wurde;
ein Vergleichsmittel (340) zum Vergleichen der Phasendifferenz, die von dem Phasendifferenzdetektionsmittel (320) detektiert wurde, und einer Zielphasendifferenz zum Optimieren der Ansteuerfrequenz des Vibrators; und
ein Steuermittel zum Variieren der Ansteuerfrequenz des Ansteuersignals auf der Basis der Vergleichsergebnisse von dem Vergleichsmittel (340), so dass die Phasendifferenz, die von dem Phasendifferenzdetektionsmittel (320) detektiert wurde, näher zu der Zielphasendifferenz gebracht wird, nachdem die Zielphasendifferenz und die Phasendifferenz, die von dem Phasendifferenzdetektionsmittel (320) detektiert wurde, von dem Vergleichsmittel (340) verglichen wurden.

2. Einrichtung (300) zum Ansteuern eines piezoelektrischen Stellgliedes (A) nach Anspruch 1, **dadurch gekennzeichnet, dass**:
das Phasenverschiebungsmittel aus einem nicht-linearen Element konfiguriert ist.

3. Einrichtung (300) zum Ansteuern eines piezoelektrischen Stellgliedes (A) nach Anspruch 2, **dadurch gekennzeichnet, dass**
das nicht-lineare Element eine Diode ist.

4. Einrichtung (300) zum Ansteuern eines piezoelektrischen Stellgliedes (A) nach Anspruch 3, **dadurch gekennzeichnet, dass**:
die Diode die parasitäre Diode eines MOS-Transistors ist.

5. Einrichtung (300) zum Ansteuern eines piezoelektrischen Stellgliedes (A) nach Anspruch 2, **dadurch gekennzeichnet, dass**:
das nicht-lineare Element ein Transistor im Aus-Zustand ist.

6. Einrichtung (300) zum Ansteuern eines piezoelektrischen Stellgliedes (A) nach Anspruch 1, **dadurch gekennzeichnet, dass**:
das Phasenverschiebungsmittel einen Kondensator oder eine Parasitärkapazität eines MOS-Transistors und mindestens eines von einer Diode, einer parasitären Diode eines MOS-Transistors und einem Transistor in einem Aus-Zustand enthält, und
das Phasenverschiebungsmittel (330) dazu dient, die Phase des Detektionssignals auf eine korrigierte Phase zu korrigieren, wenn eine Spannung des Detektionssignals mehr als Schwellenspannung mindestens einer von der Diode, der parasitären Diode eines MOS-Transistors und dem Transistor in einem Aus-Zustand ist.

7. Elektronische Vorrichtung, **dadurch gekennzeichnet, dass** sie die Einrichtung (300) zum Ansteuern eines piezoelektrischen Stellgliedes (A) nach einem der Ansprüche 1 bis 6, ein piezoelektrisches Stellglied (A), das von dieser Einrichtung (300) angetrieben wird, und eine Leistungsquelle umfasst.

8. Verfahren zum Ansteuern einer elektronischen Vorrichtung, umfassend ein piezoelektrisches Stellglied (A) mit einem Vibrator (12), der aufgrund des Anlegens eines Ansteuersignals (SDR) mit einer vorgeschriebenen Ansteuerfrequenz an ein piezoelektrisches Element vibriert; ein Ansteuermittel (310) zum Zuleiten des Ansteuersignals (SDR) zu dem piezoelektrischen Element des Vibrators (12), und eine Leistungsquelle; wobei das Verfahren zum Ansteuern einer elektronischen Vorrichtung umfasst:
einen Phasenverschiebungsschritt zum Korrigieren einer Phase eines Detektionssignals (SD1), das den vibrierenden Zustand des Vibrators (12) anzeigt, auf der Basis der Spannung des Detektionssignals (SD1);
einen Phasendifferenzdetektionsschritt zum Detektieren einer Phasendifferenz zwischen dem Ansteuersignal (SDR) und dem Detektionssignal (SD1a), dessen Phase in dem Phasenverschiebungsschritt korrigiert wurde;
einen Vergleichsschritt zum Vergleichen der Phasendifferenz, die in dem Phasendifferenzdetektionsschritt detektiert wurde, und einer Zielphasendifferenz zum Optimieren der Ansteuerfrequenz des Vibrators, nachdem die Phase des Detektionssignals in dem Phasenverschiebungsschritt korrigiert wurde; und
einen Steuerschritt zum Variieren der Ansteuerfrequenz des Ansteuersignals auf der Basis der Vergleichsergebnisse aus dem Vergleichsschritt, so dass die Phasendifferenz, die in dem Phasendifferenzdetektionsschritt detektiert wurde, näher zu der Zielphasendifferenz gebracht wird, nachdem die Zielphasendifferenz und die Phasendifferenz, die in dem Phasendifferenzdetektionsschritt detektiert wurde, in dem Vergleichsschritt verglichen wurden.

## Revendications

1. Appareil (300) pour commander un actionneur piézoélectrique (A) ayant un oscillateur (12) qui oscille en raison de l'application d'un signal d'attaque (SDR) ayant une fréquence d'attaque prescrite à un élément piézoélectrique ; ledit appareil (300) pour commander un actionneur piézoélectrique (A) comprenant :
un moyen de commande (310) pour fournir le signal d'attaque (SDR) à l'élément piézoélectrique de l'oscillateur (12) ;
un moyen de décalage de phase (330) pour corriger une phase d'un signal de détection (SD1) indiquant l'état d'oscillation de l'oscillateur (12) sur la base de la tension du signal de détection (SD1) ;
un moyen de détection de différence de phase (320) pour détecter une différence de phase entre le signal d'attaque (SDR) et le signal de détection (SD1a) dont la phase a été corrigée par le moyen de décalage de phase (330) ;
un moyen de comparaison (340) pour comparer la différence de phase détectée par le moyen de détection de différence de phase (320) et une différence de phase cible pour optimiser la fréquence d'attaque de l'oscillateur ; et
un moyen de contrôle pour faire varier la fréquence d'attaque du signal d'attaque sur la base des résultats de comparaison du moyen de comparaison (340) de manière à ce que la différence de phase détectée par le moyen de détection de différence de phase (320) se rapproche davantage de la différence de phase cible une fois que ladite différence de phase cible et ladite différence de phase détectée par le moyen de détection de différence de phase (320) ont été comparées par ledit moyen de comparaison (340).

2. Appareil (300) pour commander un actionneur piézoélectrique (A) selon la revendication 1, **caractérisé en ce que** :
le moyen de décalage de phase est configuré à partir d'un élément non linéaire.

3. Appareil (300) pour commander un actionneur piézoélectrique (A) selon la revendication 2, **caractérisé en ce que** :
l'élément non linéaire est une diode.

4. Appareil (300) pour commander un actionneur piézoélectrique (A) selon la revendication 3, **caractérisé en ce que** :
la diode est la diode parasite d'un transistor MOS.

5. Appareil (300) pour commander un actionneur piézoélectrique (A) selon la revendication 2, **caractérisé en ce que** :
l'élément non linéaire est un transistor dans un état éteint.

6. Appareil (300) pour commander un actionneur piézoélectrique (A) selon la revendication 1, **caractérisé en ce que** :
le moyen de décalage de phase comprend un condensateur ou une capacité parasite d'un transistor MOS et au moins l'un(e) parmi une diode, une diode parasite d'un transistor MOS et un transistor dans un état éteint, et
le moyen de décalage de phase (330) étant adapté pour corriger la phase du signal de détection à une phase corrigée lorsqu'une tension dudit signal de détection est supérieure à une tension de seuil d'au moins l'un(e) parmi la diode, la diode parasite d'un transistor MOS et un transistor dans un état éteint.

7. Dispositif électronique, **caractérisé en ce qu'**il comprend l'appareil (300) pour commander un actionneur piézoélectrique (A) selon l'une quelconque des revendications 1 à 6, un actionneur piézoélectrique (A) commandé par cet appareil (300), et une source d'alimentation.

8. Procédé pour commander un dispositif électronique comprenant un actionneur piézoélectrique (A) ayant un oscillateur (12) qui oscille en raison de l'application d'un signal d'attaque (SDR) ayant une fréquence d'attaque prescrite à un élément piézoélectrique, un moyen de commande (310) pour fournir le signal d'attaque (SDR) à l'élément piézoélectrique de l'oscillateur (12), et une source d'alimentation ; ledit procédé de commande de dispositif électronique comprenant :
une étape de décalage de phase consistant à corriger une phase d'un signal de détection (SD1) indiquant l'état d'oscillation de l'oscillateur (12) sur la base de la tension du signal de détection (SD1) ;
une étape de détection d'une différence de phase consistant à détecter une différence de phase entre le signal d'attaque (SDR) et le signal de détection (SD1a) dont la phase a été corrigée lors de l'étape de décalage de phase;
une étape de comparaison consistant à comparer la différence de phase détectée lors de l'étape de détection d'une différence de phase et une différence de phase cible pour optimiser la fréquence d'attaque de l'oscillateur une fois que la phase du signal de détection a été corrigée lors de l'étape de décalage de phase ; et
une étape de contrôle consistant à faire varier la fréquence d'attaque du signal d'attaque sur la base des résultats de comparaison de l'étape de comparaison de manière à ce que la différence de phase détectée lors de l'étape de détection d'une différence de phase se rapproche davantage de la différence de phase cible une fois que ladite différence de phase cible et ladite différence de phase détectée lors de l'étape de détection de différence de phase ont été comparées dans ledit moyen de comparaison.
